(19)

**Europäisches Patentamt**
**European Patent Office**
**Office européen des brevets**

(11)  **EP 4 756 070 A1**

(12)  **EUROPEAN PATENT APPLICATION**
published in accordance with Art. 153(4) EPC

(43) Date of publication:
**10.06.2026  Bulletin 2026/24**

(21) Application number: **24849689.5**

(22) Date of filing: **01.08.2024**

(51) International Patent Classification (IPC):
*C23C 14/22* (2006.01)      *H10K 71/16* (2023.01)
*H10K 50/15* (2023.01)      *H10K 50/16* (2023.01)
*H10K 50/11* (2023.01)      *H10K 59/80* (2023.01)
*C23C 14/04* (2006.01)      *C23C 14/34* (2006.01)
*C23C 14/24* (2006.01)

(52) Cooperative Patent Classification (CPC):
**C23C 14/04; C23C 14/22; C23C 14/24;**
**C23C 14/34; H10K 50/11; H10K 50/15;**
**H10K 50/16; H10K 59/80; H10K 71/16**

(86) International application number:
**PCT/KR2024/095947**

(87) International publication number:
**WO 2025/029122 (06.02.2025 Gazette 2025/06)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **02.08.2023  KR 20230101292**
**20.11.2023  KR 20230160697**
**31.07.2024  KR 20240101763**

(71) Applicant: **Yas Co., Ltd.**
**Paju-si, Gyeonggi-do 10857 (KR)**

(72) Inventors:
• **KIM, Suhwan**
**Paju-si, Gyeonggi-do 10857 (KR)**
• **KANG, Hyunuk**
**Paju-si, Gyeonggi-do 10857 (KR)**
• **CHOI, Myungwoon**
**Paju-si, Gyeonggi-do 10857 (KR)**
• **AHN, Byungchul**
**Seoul 06574 (KR)**
• **JEONG, Kwangho**
**Paju-si, Gyeonggi-do 10857 (KR)**

(74) Representative: **Epping - Hermann - Fischer**
**Patentanwaltsgesellschaft mbH**
**Schloßschmidstraße 5**
**80639 München (DE)**

(54)  **DEPOSITION EQUIPMENT AND DEPOSITION SYSTEM**

(57)      A deposition equipment for manufacturing each of a plurality of subpixels having a side-by-side structure on a substrate may include an evaporation source device positioned below the substrate to discharge a deposition material toward the substrate. The evaporation source device may include a point source or a linear source. The point source may be positioned at a distance from the substrate at least four times greater than the linear source.

FIG. 10

EP 4 756 070 A1

**Description**

## BACKGROUND OF THE DISCLOSURE

### Field

The embodiment relates to a deposition equipment and a deposition system.

### Discussion of the Related Art

As the demand for portable information media increases, organic light-emitting display devices are being applied to various lightweight and thin information electronic devices. Recently, organic light-emitting display devices are being applied to product groups such as mobile PCs and automobiles rather than TVs or mobile phones. Organic light-emitting display devices applied to mobile PCs or automobiles are driven as still images for a long time, so that long lifespan is required. For long lifespan, light extraction from organic light-emitting elements must be maximized. In order to produce long-lifespan organic light-emitting elements, subpixels having a top emission structure and a side-by-side structure must be implemented as a structure of organic light-emitting elements having two or more stacks. In addition, for low cost, it is important to expand the technology to be able to produce at least 8.5 generations (2200x2,500mm).

The main technologies emerging to implement the aforementioned structures are as follows.

First, there is a method of applying a fine metal mask (hereinafter referred to as FMM) on a large screen. Second, there is a method of patterning organic light-emitting elements in units of subpixels using photolithography. This method can be called PhSbS (Side by side structure by photolithography). Third, there is a method of depositing at different deposition angles for each subpixel or material in a three-dimensional subpixel structure.

In addition to these three methods, technology for freely controlling and managing the deposition angle and the deposition equipment and deposition system that implement it can become the basis for producing innovative organic light-emitting display devices in the future. The core of this technology is to accurately deposit the deposition material in the design-required location in the deposition equipment.

First, when manufacturing an organic light-emitting display device using FMM, there is a problem that the pixel position accuracy (PPA) of the subpixel unit between the FMM and the substrate is low. In addition, when manufacturing an organic light-emitting display device using FMM, even if the alignment of the subpixel units is well done, there is a problem that the difference in the pixel position accuracy occurs due to the shadow effect caused by FMM. In addition, precise deposition positions for each deposition material are essential for the PhSbS structure. In addition, a technology for accurately implementing the deposition angle of the deposition material is required in order to implement a new structure that configures an organic light-emitting element on a three-dimensional structure.

The invention of this new deposition technology can ultimately improve the emission area ratio (EAR) of the product, thereby improving the lifespan of the product. In addition, the production of a large-area substrate is possible, which improves productivity and increases the material utilization efficiency of the organic light-emitting element. Here, the emission area ratio is the value obtained by dividing the emission area of the subpixel by the area of the subpixel.

## SUMMARY OF THE DISCLOSURE

An object of the embodiment is to solve the foregoing and other problems.

Another object of the embodiment is to provide a deposition equipment and a deposition system capable of improving productivity by patterning an organic emitting layer in a side-by-side structure with or without using an FMM in a deposition process and depositing at different deposition angles according to a three-dimensional structure.

Another object of the embodiment is to provide a deposition equipment and a deposition system capable of freely changing the deposition angle.

The technical problems of the embodiments are not limited to those described in this item and comprise those that can be understood through the description of the invention.

In order to achieve the above or other objects, according to one aspect of the embodiment to achieve the above or other objects, a deposition equipment for manufacturing each of a plurality of subpixels having a side-by-side structure on a substrate, comprising: an evaporation source device positioned below the substrate to discharge a deposition material toward the substrate, wherein the evaporation source device comprises a point source or a linear source, and wherein the point source is positioned at a distance from the substrate at least four times or more greater than the linear source.

A range of a deposition angle of the point source in a scan direction and a range of a deposition angle of the point source in a direction orthogonal to the scan direction may be the same.

The plurality of subpixels comprises a blue subpixel, a green subpixel, and a red subpixel, and the blue subpixel, the green subpixel, and the red subpixel may comprise a plurality of organic emitting layers, respectively.

When at least one or more organic emitting layer among the plurality of organic emitting layers is formed on the substrate using a mask positioned between the substrate and the point source, a range of a deposition angle of the point source may be 60° to 120°, and the at least one or more organic emitting layer may be individually formed on the blue subpixel, the green subpixel, and the red subpixel through the mask.

The plurality of subpixels may comprise a blue subpixel, a green subpixel, and a red subpixel, each of the blue subpixel, the green subpixel, and the red subpixel may comprise a hole injection layer on an anode electrode and at least one or more stack structure on the hole injection layer, and when the hole injection layer is formed on the substrate using a protrusion part between the plurality of subpixels as a mask, a range of a deposition angle of the point source may be 60° to 120°.

The at least or more one stack structure may comprise a first stack structure and a second stack structure, each of the blue subpixel, the green subpixel, and the red subpixel may further comprise a charge generation layer between the first stack structure and the second stack structure, and when the charge generation layer is formed on the substrate using a protrusion part as a mask, a range of a deposition angle of the point source may be 60° to 120°.

The plurality of subpixels may comprise a blue subpixel, a green subpixel, and a red subpixel, the blue subpixel, the green subpixel, and the red subpixel may commonly comprise a blue organic emitting layer, and when a plurality of three-dimensional structures on the substrate are used as masks to form the blue organic emitting layer on the substrate, a range of a deposition angle of the point source may be 70° to 110°.

The evaporation source device may comprises a first evaporation source device comprising a first-first evaporation source device, a first-second evaporation source device, and a first-third evaporation source device disposed in a row along a scan direction, and a second evaporation source device comprising a second-first evaporation source device, a second-second evaporation source device, and a second-third evaporation source device disposed in a row along the scan direction and spaced apart from the first evaporation source device along a direction orthogonal to the scan direction.

Each of the first-second evaporation source device and the second-second evaporation source device may comprise a dopant material as the deposition material, and each of the first-first evaporation source device, the first-third evaporation source device, the second-first evaporation source device, and the second-third evaporation source device may comprise a host material as the deposition material.

The first-first evaporation source device may comprise a plurality of first-first point sources disposed in a circular shape along a circumference of its upper side, the first-second evaporation source device may comprise a plurality of first-second point sources disposed in a circular shape along a circumference of its upper side, the first-third evaporation source device may comprise a plurality of first-third point sources disposed in a circular shape along a circumference of its upper side, and one of the plurality of first-first point sources, one of the plurality of first-second point sources, and one of the plurality of first-third point sources may be positioned on a straight line.

The second-first evaporation source device may comprise a plurality of second-first point sources disposed in a circular shape along a circumference of its upper side, the second-second evaporation source device may comprise a plurality of second-second point sources disposed in a circular shape along a circumference of its upper side, the second-third evaporation source device may comprise a plurality of second-third point sources disposed in a circular shape along a circumference of its upper side, and one of the plurality of second-first point sources, one of the plurality of second-second point sources, and one of the plurality of second-third point sources may be positioned on a straight line.

The evaporation source device comprising the point source may have a cylindrical structure, and the evaporation source device comprising the linear source may have a rectangular hexahedron structure elongated in a direction orthogonal to a scan direction.

According to another aspect of the embodiment to achieve the above or other objects, a deposition system, comprising: a plurality of deposition equipment configured in a circular type or an inline type, and one of the plurality of deposition equipment may be a deposition equipment described above.

The effects of the deposition equipment and the deposition system according to the embodiment are described as follows.

According to at least one of the embodiments, the organic emitting layer can be patterned in a side-by-side structure with or without using FMM in the deposition process, and can be deposited at different deposition angles to match the three-dimensional structure, thereby improving productivity. Accordingly, the product lifespan can be improved by improving the emission area ratio, productivity can be improved by enabling the production of a large-area substrate, and the material utilization efficiency of an organic light-emitting element can be increased.

According to at least one of the embodiments, the deposition angle can be freely changed,

Depending on the structure of the product, it is possible to solve the problem of image quality and yield degradation due to short circuit or current leakage between the cathode electrode and the anode electrode of the organic light-emitting element between subpixels or within a subpixel.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

## BRIEF DESCRIPTION OF THE DRAWINGS

FIG. 1 illustrates a substrate according to an embodiment.

FIG. 2 illustrates a deposition of a deposition material on a substrate using an FMM.

FIG. 3 is an enlarged view of area A shown in FIG. 2.

FIG. 4 illustrates a red organic light-emitting element, a green organic light-emitting element, and a blue organic light-emitting element deposited on the substrate of FIG. 1.

FIG. 5 is a plan view illustrating a deposition system according to the first embodiment.

FIG. 6A is a cross-sectional view taken along line A1-A2 in the first deposition equipment of FIG. 5.

FIG. 6B is a cross-sectional view taken along line B1-B2 in the first deposition equipment of FIG. 5.

FIG. 7A is a cross-sectional view taken along line C1-C2 in the sixth deposition equipment of FIG. 5.

FIG. 7B is a cross-sectional view taken along line D1-D2 in the sixth deposition equipment of FIG. 5.

FIG. 8A is a plan view illustrating a red subpixel, a green subpixel, and a blue subpixel constituting one pixel on a substrate having a protrusion part according to an embodiment.

FIG. 8B is a cross-sectional view taken along line E1-E2 in the pixel of FIG. 8A.

FIG. 9 illustrates a red organic light-emitting element, a green organic light-emitting element, and a blue organic light-emitting element deposited on the substrate of FIG. 8B.

FIG. 10 is a cross-sectional view illustrating a deposition system according to a second embodiment.

FIG. 11 illustrates a red organic light-emitting element, a green organic light-emitting element, and a blue organic light-emitting element each having a two-stack structure deposited on the substrate of FIG. 8B.

FIG. 12 is a cross-sectional view illustrating a deposition system according to a third embodiment.

FIG. 13 is a cross-sectional view illustrating a red organic emitting layer, a green organic emitting layer, and a blue organic emitting layer disposed on a substrate having a three-dimensional structure according to an embodiment.

FIG. 14 illustrates a red organic light-emitting element, a green organic light-emitting element, and a blue organic light-emitting element deposited on a substrate having a three-dimensional structure according to an embodiment.

FIG. 15 is a cross-sectional view illustrating a deposition system according to a fourth embodiment.

FIG. 16 illustrates a blue organic emitting layer being deposited according to an embodiment.

FIG. 17 illustrates a red organic emitting layer being deposited according to an embodiment.

FIG. 18 illustrates a green organic emitting layer being deposited according to an embodiment.

FIG. 19 is a plan view illustrating a deposition equipment according to a first embodiment.

FIG. 20A is a plan view illustrating a deposition equipment according to a first embodiment.

FIG. 20B illustrates a view along the C1-C2 line in the deposition equipment according to the first embodiment.

FIG. 20C illustrates a view along the D1-D2 line in the deposition equipment according to the first embodiment.

FIG. 21 is a table showing the deposition characteristics in the deposition equipment according to a first embodiment.

FIG. 22A is a plan view showing the deposition equipment according to a second embodiment.

FIG. 22B is a view showing the deposition equipment according to the second embodiment along the C1-C2 line.

FIG. 22C is a view showing the deposition equipment according to the second embodiment along the D1-D2 line.

FIG. 23 is a table showing the deposition characteristics in the deposition equipment according to the second embodiment.

FIG. 24A is a plan view showing the deposition equipment according to a third embodiment.

FIG. 24B is a view showing the deposition equipment according to the third embodiment along the C1-C2 line.

FIG. 24C is a view showing the deposition equipment according to the third embodiment along the D1-D2 line.

FIG. 25 is a table showing the deposition characteristics in the deposition equipment according to the third embodiment.

FIG. 26A is a plan view illustrating a deposition equipment according to a fourth embodiment.

FIG. 26B is a plan view illustrating a deposition equipment according to the fourth embodiment along the C1-C2 line.

FIG. 26C is a plan view illustrating a deposition equipment according to the fourth embodiment along the D1-D2 line.

FIG. 27 is a table illustrating deposition characteristics in a deposition equipment according to the fourth embodiment.

FIG. 28A is a plan view illustrating a deposition equipment according to a fifth embodiment.

FIG. 28B is a plan view illustrating a deposition equipment according to the fifth embodiment along the C1-C2 line.

FIG. 28C is a plan view illustrating a deposition equipment according to the fifth embodiment along the D1-D2 line.

FIG. 29 is a table illustrating deposition characteristics in a deposition equipment according to the fifth embodiment.

FIGS. 30A, 30B, and 30C illustrate nozzles provided on the upper side of a point source according to the first embodiment.

FIGS. 31A, 31B, and 31C illustrate nozzles provided on the upper side of a point source according to the second embodiment.

FIGS. 32A, 32B, and 32C illustrate nozzles provided on the upper side of a point source according to the third embodiment.

The sizes, shapes, dimensions, etc. of elements shown in the drawings can differ from actual ones. In addition, even if the same elements are shown in different sizes, shapes, dimensions, etc. between the drawings, this is only an example on the drawing, and the same elements have the same sizes, shapes, dimensions, etc. between the drawings.

## DETAILED DESCRIPTION OF EMBODIMENTS

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there can be directly on the other element or be other intermediate elements therebetween.

Hereinafter, the range of the deposition angle may be determined based on the horizontal direction or the horizontal line from the left side to the right side. The values listed in each table below may vary depending on various variables such as the target-source distance of each evaporation source device, the location of each evaporation source device, and the type of deposition material discharged from each evaporation source device. Nevertheless, the target-source distance of the point source may be at least four times or more greater than the target-source distance of the linear source. In other words, the point source can be positioned much further away from the substrate than the linear source, so that the deposition material can be deposited onto the substrate in a smaller range of deposition angle. While the point source sprays the deposition material in a dot shape through a single nozzle, the linear source sprays the deposition material in a line shape through the plurality of nozzles disposed in a row. As will be explained later, it is advantageous to adopt a point source rather than a linear source in order to secure a high angle for spraying the deposition material in the vertical direction.

The structures of the organic light-emitting display device described below are representative examples, and various structural modifications may be possible in addition to these.

[Deposition equipment and deposition system using FMM]

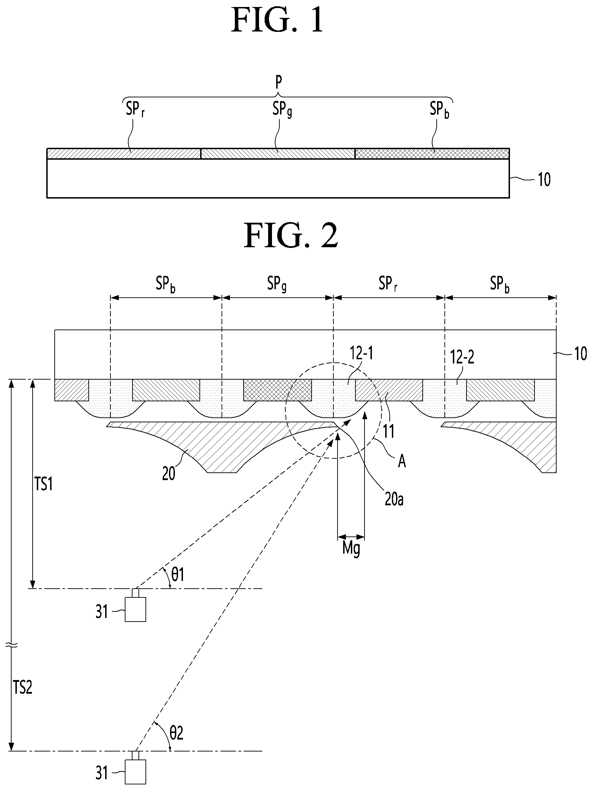

FIG. 1 illustrates a substrate according to an embodiment.

As shown in FIG. 1, a pixel P may be defined on a substrate 10, and the pixel P may comprise a red subpixel SPr, a green subpixel SPg, and a blue subpixel SPb. Although one pixel P is defined in the drawing, a plurality of pixels P may be arranged, for example, in a matrix, on the substrate 10. Although three subpixels SPr, SPg, and SPb are illustrated in the drawing, more subpixels may be included in one pixel P.

A red organic light-emitting element may be disposed in the red subpixel SPr, a green organic light-emitting element may be disposed in the green subpixel SPg, and a blue organic light-emitting element may be disposed in the blue subpixel SPb. An organic light-emitting display device capable of displaying an image may be implemented through the configuration of the red organic light-emitting element, the green organic light-emitting element, and the blue organic light-emitting element.

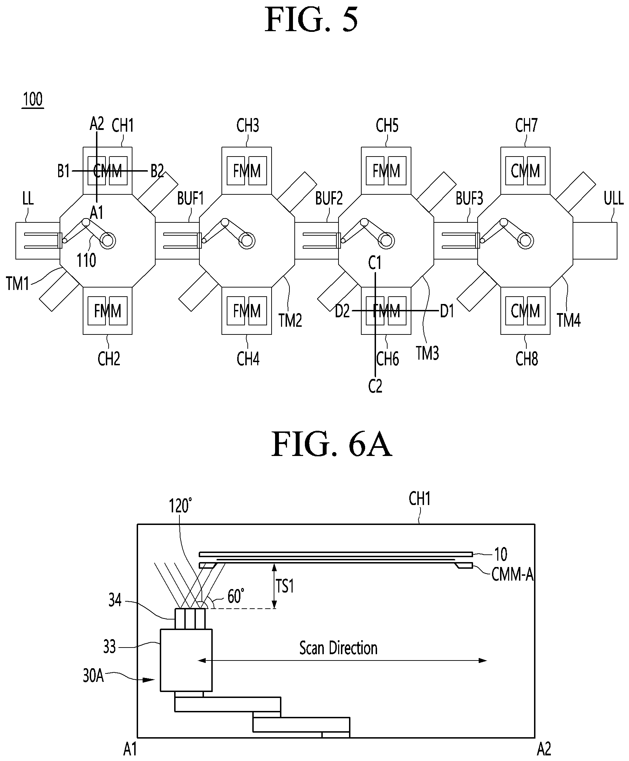

The red organic light-emitting element, the green organic light-emitting element, and the blue organic light-emitting element can be deposited on the substrate 10 using corresponding deposition equipment, respectively. These deposition equipment can be included in a cluster-type deposition system, as shown in FIG. 5, but are not limited thereto.

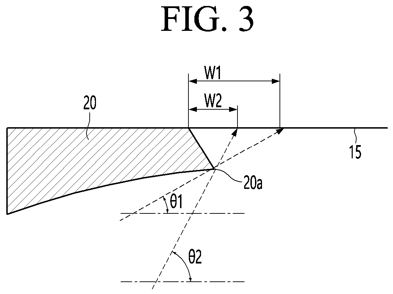

FIG. 2 illustrates a deposition of a deposition material on a substrate using an FMM. FIG. 3 is an enlarged view of area A shown in FIG. 2.

As shown in FIG. 2, an anode electrode 11 can be disposed on the substrate 10 corresponding to each of the red subpixel SPr, the green subpixel SPg, and the blue subpixel SPb. The anode electrodes 11 disposed on each of the red subpixel SPr, the green subpixel SPg, and the blue subpixel SPb can be electrically disconnected by being spaced apart from each other. Banks 12-1 and 12-2 may be disposed between the red subpixel SPr, the green subpixel SPg, and the blue subpixel SPb.

A substrate 10 equipped with an anode electrode 11 and banks 12-1 and 12-2 may be transferred to a deposition equipment, and a predetermined organic light-emitting element may be deposited on the substrate 10 in the deposition equipment.

An evaporation source device 31 may be equipped in the deposition equipment. For example, the evaporation source device 31 may be positioned at the lower side of the chamber and may spray a deposition material toward the substrate 10 positioned at the upper side of the chamber. The substrate 10 may be positioned such that the anode electrode 11 or the banks 12-1 and 12-2 face the evaporation source device 31. Accordingly, a deposition material, for example, an organic light-emitting material, discharged toward the substrate 10 from the evaporation source device 31 may be deposited on the substrate 10.

Meanwhile, the FMM 20 may be positioned between the evaporation source device 31 and the substrate 10. The FMM 20 may be positioned as close to the substrate 10 as possible so that the gap between FMM 20 and substrate 10 can be widened to prevent the deposition area from being reduced. The FMM 20 may be a mask in which an opening is formed so that the organic light-emitting material may be deposited only on a specific area on the substrate 10.

As shown in FIG. 2, an FMM 20 in which an opening is formed corresponding to a red subpixel SPr on a substrate 10 may be provided. The opening may correspond to an area between half of a first bank 12-1 positioned between a blue subpixel SPb and a red subpixel SPr and half of a second bank 12-2 positioned between a red subpixel SPr and a green subpixel SPg. A red organic light-emitting material may be loaded into the evaporation source device 31.

The FMM 20 may be accurately aligned with the substrate 10. The degree of alignment may be referred to as pixel position accuracy (PPA). In the deposition process using FMM 20, PPA can be determined by the position tolerance of the pattern of the substrate 10, the position tolerance through the manufacturing of FMM 20, the deposition shadow tolerance of FMM 20, the alignment position tolerance of the deposition equipment, etc. Each tolerance may comprise a more detailed factor-specific tolerance.

In order for the organic light-emitting material to be deposited on the red subpixel SPr with the largest possible area, the alignment margin Mg of FMM 20 must be secured. The alignment margin Mg of FMM 20 may be the gap between the edge 20A of FMM 20 and the end of the anode electrode 11 exposed by the banks 12-1 and 12-2.

In order for the red organic light-emitting material to be deposited on the red subpixel SPr with the largest possible area, FMM 20 may have a geometric shape. For example, the thickness of FMM 20 may be maximum in the corresponding area between each subpixel SPr, SPg and SPb, and the thickness of the FMM 20 may decrease as it goes toward the adjacent subpixel and as the distance from the substrate 10 gets closer, but are not limited thereto. Since various shapes of the FMM 20 are widely known, a detailed description is omitted.

Meanwhile, an edge 20A may be provided in contact with the opening of the FMM 20. A shadow phenomenon may occur due to the edge 20A. That is, since the edge 20A of the FMM 20 is provided at the end of the lower surface spaced from the upper surface of the FMM 20, a shadow phenomenon may occur as much as the thickness between the edge 20A and the upper surface of the FMM 20. There is a problem that this shadow phenomenon reduces the area of the organic light-emitting material deposited on the red subpixel SPr, which reduces light extraction and shortens the lifespan.

Meanwhile, the area where the organic light-emitting material via edge 20A is deposited on the red subpixel SPr may vary depending on the location of the evaporation source device 31.

For example, the evaporation source device 31 may be positioned at a first target-source distance TS1 or at a second target-source distance TS2. The deposition angle θ2 of the organic light-emitting material discharged via edge 20A from the evaporation source device 31 positioned at a second target-source distance TS2 may be greater than the deposition angle θ1 of the organic light-emitting material discharged via edge 20A from the evaporation source device 31 positioned at a first target-source distance TS1.

In the instance, as shown in FIG. 3, the shadow width W2 by the organic light-emitting material deposited on the deposition surface 15 at the deposition angle θ2 may be smaller than the shadow width W1 by the organic light-emitting material deposited on the deposition surface 15 at the deposition angle θ1. Therefore, the organic light-emitting material discharged at the deposition angle θ2, which is greater than the deposition angle θ1, may be deposited over a larger area in the red subpixel SPr. The deposition angle θ1 and the deposition angle θ2 may be angles with respect to the horizontal line. That is, the deposition angle θ1 and the deposition angle θ2 may be angles with respect to the horizontal direction or the horizontal line from the left side to the right side.

The deposition angle θ1 and the deposition angle θ2 may also be defined as angles with respect to the normal line.

For example, the shadow phenomenon of FMM 20 may be reduced by more than 50% by increasing the target-source distance TS1 and TS2. Accordingly, the deposition area of the red subpixel SPr may be expanded, thereby implementing a long lifespan.

Meanwhile, theoretically, when the deposition angle is 90 degrees, the largest area of the organic light-emitting material can be deposited on the red subpixel SPr. However, since the organic light-emitting material is discharged from the evaporation source device 31 and disperses as it progresses, the evaporation source device 31 must be positioned very far away from the substrate 10. In the instance, there is a problem that the size of the deposition equipment becomes very large.

In the embodiment, the organic light-emitting material having the largest area can be deposited on the red subpixel SPr through modifications of various structures, positions, etc., as well as the target-source distance TS1 and TS2.

In the above, referring to FIGS. 2 and 3, the description is limited to the deposition of the organic light-emitting material on the red subpixel SPr, but the above description can also be applied equally to the deposition of the organic light-emitting material on each of the green subpixel SPg and the blue subpixel SPb.

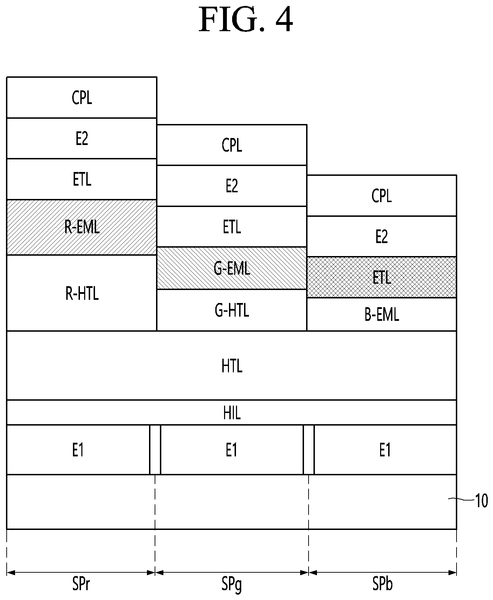

FIG. 4 illustrates a red organic light-emitting element, a green organic light-emitting element, and a blue organic light-emitting element deposited on the substrate 10 of FIG. 1.

As shown in FIG. 4, a red organic light-emitting element, a green organic light-emitting element, and a blue organic light-emitting element can be disposed on the substrate 10. That is, a red organic light-emitting element can be disposed on the red subpixel SPr, a green organic light-emitting element can be disposed on the green subpixel SPg, and a blue organic light-emitting element can be disposed on the blue subpixel SPb.

Specifically, in the red subpixel SPr, a hole injection layer HIL, a red hole transport layer R-HTL, a red organic emitting layer R-EML, an electron transport layer ETL, etc. may be deposited on the anode electrode E1. In the green subpixel SPg, a hole injection layer HIL, a green hole transport layer G-HTL, a green organic emitting layer G-EML, an electron transport layer ETL, etc. may be deposited on the anode electrode E1. In the blue subpixel SPb, a hole injection layer HIL, a hole transport layer HTL, a blue organic emitting layer B-EML, a blue electron transport layer ETL, etc. may be deposited on the anode electrode E1.

The hole injection layer HIL, the hole transport layer HTL, the electron transport layer ETL, the cathode electrode E2, the capping layer CPL, etc. may be commonly formed on the red subpixel SPr, the green subpixel SPg, and the blue subpixel SPb. The arrangement order of the hole injection layer HIL and the hole transport layer HTL can be changed. Although not shown, an electron injection layer may be deposited between the electron transport layer ETL and the cathode electrode E2. As described above, the hole injection layer HIL and/or the hole transport layer may be included in the hole transport structure, the electron transport layer and the electron injection layer may be included in the electron transport structure, and the hole transport structure and the electron transport structure may each comprise more organic emitting layers than these.

Meanwhile, the cathode electrode E2 and the capping layer CPL may be deposited on the electron transport layer ETL in each of the red subpixel SPr, the green subpixel SPg, and the blue subpixel SPb.

Meanwhile, as shown in FIG. 4, the red organic light-emitting element, the green organic light-emitting element, and the blue organic light-emitting element may have different thicknesses from each other. The distance between the anode electrode El and the cathode electrode E2 of the red organic light-emitting element, the distance between the anode electrode E1 and the cathode electrode E2 of the green organic light-emitting element, and the distance between the anode electrode E1 and the cathode electrode E2 of the blue organic light-emitting element may be different. These thicknesses or distances may be determined in consideration of the wavelength of the corresponding color.

The distance between the anode electrode E1 and the cathode electrode E2 of each of the red organic light-emitting element, the green organic light-emitting element, and the blue organic light-emitting element may be designed so that the wavelength of light of each of the red organic light-emitting element, the green organic light-emitting element, and the blue organic light-emitting element satisfies Equation 1. Thus, constructive interference occurs in each of the red organic light-emitting element, the green organic light-emitting element, and the blue organic light-emitting element. In other words, the distance between the anode electrode E1 and the cathode electrode E2 of each of the red organic light-emitting element, the green organic light-emitting element, and the blue organic light-emitting element may be designed to be a multiple of the wavelength $\lambda$ of light. This may be expressed by Equation 1.

[Equation 1]

$$2nd = m\lambda$$

n may represent the effective refractive index of each of the red organic light-emitting element, the green organic light-emitting element, and the blue organic light-emitting element. d may represent the distance between the anode electrode El and the cathode electrode E2 in each of the red organic light-emitting element, the green organic light-emitting element, and the blue organic light-emitting element. m may represent the order, and $\lambda$ may represent the wavelength of light generated from each of the red organic light-emitting element, the green organic light-emitting element, and the blue organic light-emitting element.

As shown in Equation 1, as the wavelength $\lambda$ increases, the distance d between the anode electrode E1 and the cathode electrode E2 in each of the red organic light-emitting element, the green organic light-emitting element, and the blue organic light-emitting element may increase.

Meanwhile, in the top emission type structure, the anode electrode E1 of each of the red organic light-emitting element, the green organic light-emitting element, and the blue organic light-emitting element may be a reflective electrode and the cathode electrode E2 may be a semi-transmissive electrode so that constructive interference occurs in each of the red organic light-emitting element, the green organic light-emitting element, and the blue organic light-emitting element. The semi-transmissive electrode may comprise, for example, a single layer of a Mg:Ag alloy or a double layer comprising a first layer made of a Mg:Ag alloy and a second layer made of a transparent conductive material such as ITO, but is not limited thereto.

Meanwhile, in order to satisfy Equation 1, different distances between the anode electrode E1 and the cathode electrode E2 should be achieved in each of the red organic light-emitting element, the green organic light-emitting element, and the blue organic light-emitting element. To this end, in the embodiment, the thicknesses of the red organic emitting layer R-EML, the green organic emitting layer G-EML, and the blue organic emitting layer B-EML may be designed differently. In addition to the hole transport layer HTL commonly included in the red organic light-emitting element, the green organic light-emitting element, and the blue organic light-emitting element, the thicknesses of the red hole transport layer R-HTL included in the red organic light-emitting element and the green hole transport layer G-HTL included in the green organic light-emitting element may be designed differently. In this way, since the thickness of the red hole transport layer R-HTL included in the red organic light-emitting element and the thickness of the green hole transport layer G-HTL included in the green organic light-emitting element are designed differently, the distances between the anode electrode E1 and the cathode electrode E2 of the red organic light-emitting element, the green organic light-emitting element, and the blue organic light-emitting element, respectively, can be made different so as to satisfy Equation 1.

Therefore, since the distances between the anode electrode E1 and the cathode electrode E2 of the red organic light-emitting element, the green organic light-emitting element, and the blue organic light-emitting element are designed differently to satisfy Equation 1, constructive interference occurs in each of the red organic light-emitting element, the green organic light-emitting element, and the blue organic light-emitting element, so that the light-emitting efficiency can be maximized.

FIG. 5 is a plan view illustrating a deposition system according to the first embodiment.

As shown in FIG. 5, the deposition system 100 according to the first embodiment may be a cluster-type deposition system, but is not limited thereto.

A plurality of transfer modules TM1 to TM4 may be disposed between the loading equipment LL and the unloading equipment ULL. A plurality of deposition equipment CH1 to CH8 may be connected to each of the plurality of transfer modules TM1 to TM4. A plurality of buffer equipment BUF1 to BUF3 may be disposed between the plurality of transfer modules TM1 to TM4.

Referring to FIG. 2 and FIG. 5, the substrate 10 may be loaded into the deposition system 100 according to the first embodiment through the loading equipment LL and may be transported to the outside through the unloading equipment ULL. Each of the plurality of transfer modules TM1 to TM4 may transport the substrate 10 to each of the plurality of deposition equipment CH1 to CH8 or return the substrate 10 from each of the deposition equipment CH1 to CH8. To this end, each of the plurality of transfer modules TM1 to TM4 may be equipped with an arm 110.

For example, the substrate 10 can be loaded into the first transfer module TM1 via the loading equipment LL, and the first transfer module TM1 can transfer and return the substrate 10 in the order of the first deposition equipment CH1 and the second deposition equipment CH2 via the arm 110. The substrate 10 can be transferred from the first transfer module TM1 to the second transfer module TM2 via the first buffer equipment BUF1. The substrate 10 can be transferred and returned in the order of the third deposition equipment CH3 and the fourth deposition equipment CH4 from the second transfer module TM2.

The substrate 10 can be transferred from the second transfer module TM2 to the third transfer module TM3 via the second buffer equipment BUF2. The substrate 10 can be transferred and returned in the order of the fifth deposition equipment CH5 and the sixth deposition equipment CH6 from the third transfer module TM3. The substrate 10 can be transferred from the third transfer module TM3 to the fourth transfer module TM4 via the third buffer equipment BUF3. The substrate 10 can be transferred and returned in the order of the seventh deposition equipment CH7 and the eighth deposition equipment CH8 from the fourth transfer module TM4. The substrate 10 can be taken out from the fourth transfer module TM4 via the unloading equipment ULL.

Although not shown, the ninth deposition equipment CH9 can be connected to the fourth transfer module TM4, so that the substrate 10 returned from the eighth deposition equipment CH8 can be transferred and returned to the ninth deposition equipment CH9, and then taken out from the outside via the unloading equipment ULL.

The first deposition equipment CH1 to the ninth deposition equipment CH9 are as shown in Table 1.

[Table 1]

| Deposition equipment | Deposition material | Range of deposition angle | |
| --- | --- | --- | --- |
| | | Scan direction | Orthogonal direction |
| CH1 | HIL, HTL | 60° ~ 120° | 22° ~ 158° |
| CH2 | G-HTL | 60° ~ 120° | 60° ~ 120° |
| CH3 | R-HTL | 60° ~ 120° | 60° ~ 120° |
| CH4 | B-EML | 60° ~ 120° | 60° ~ 120° |
| CH5 | G-EML | 60° ~ 120° | 60° ~ 120° |
| CH6 | R-EML | 60° ~ 120° | 60° ~ 120° |
| CH7 | ETL | 60° ~ 120° | 22° ~ 158° |
| CH8 | EIL, E2 | 60° ~ 120° | 22° ~ 158° |
| CH9 | CPL | 60° ~ 120° | 22° ~ 158° |

In Table 1, the deposition angle can be an angle with respect to the horizontal line. That is, the deposition angle can be an angle with respect to the horizontal direction or a horizontal line from the left side to the right side. The deposition angle can also be defined as an angle with respect to the normal line. The scan direction can be a moving direction of the body. In a cluster-type deposition system, the deposition material can be deposited on the substrate 10 while the body moves and the linear source or the point source moves with respect to the substrate 10, but is not limited thereto. The orthogonal direction can be a direction orthogonal to the scan direction. Referring to Table 1 and FIG. 4, the first deposition equipment CH1 can deposit the hole injection layer HIL or the hole transport layer HTL, and the second deposition equipment CH2 can deposit the green hole transport layer G-HTL on the hole transport layer HTL. The third deposition equipment CH3 can deposit the red hole transport layer R-HTL on the hole transport layer HTL, and the fourth deposition equipment CH4 can deposit the blue organic emitting layer B-EML on the hole transport layer HTL.

The fifth deposition equipment CH5 can deposit the green organic emitting layer G-EML on the green hole transport layer G-HTL, and the sixth deposition equipment CH6 can deposit the red organic emitting layer R-EML on the red hole transport layer R-HTL. The seventh deposition equipment CH7 can deposit the electron transport layer ETL on the blue organic emitting layer B-EML, the green organic emitting layer G-EML, and the red organic emitting layer R-EML. The eighth deposition equipment CH8 can deposit the electron injection layer or the cathode electrode E2 on the electron transport layer ETL, and the ninth deposition equipment CH9 can deposit the capping layer CPL on the cathode electrode E2.

Meanwhile, the first deposition equipment CH1, the seventh deposition equipment CH7, and the eighth deposition equipment CH8 can each deposit a deposition material on the substrate 10 using a common metal mask (hereinafter referred to as CMM). The first deposition equipment CH1, the seventh deposition equipment CH7, and the eighth deposition equipment CH8 can each comprise at least one or more linear source as an evaporation source device. As shown in Table 1, the hole injection layer HIL, the hole transport layer HTL, the electron transport layer ETL, the electron injection layer, and the cathode electrode E2 can be deposited on the substrate 10 using the CMM.

The second deposition equipment CH2 to the sixth deposition equipment CH6 can each deposit a deposition material on the substrate 10 using the FMM. The second deposition equipment CH2 to the sixth deposition equipment CH6 can each comprise at least one or more point source as an evaporation source device. As shown in Table 1, the green hole transport layer G-HTL, the red hole transport layer R-HTL, the blue organic emitting layer B-EML, the green organic emitting layer G-EML, and the red organic emitting layer R-EML can be deposited on the substrate 10 using the FMM.

As an example, the evaporation source device comprising the point source may have a cylindrical structure, and the evaporation source device comprising the linear source may have a rectangular hexahedron structure elongated along one direction. The evaporation source device comprising the point source may comprise a plurality of point sources disposed in a circular shape along the perimeter of the upper side thereof. The evaporation source device comprising the linear source may comprise a plurality of nozzles disposed along one direction on the upper side thereof. For example, the evaporation source device comprising the linear source may have a rectangular hexahedron structure elongated in an orthogonal direction.

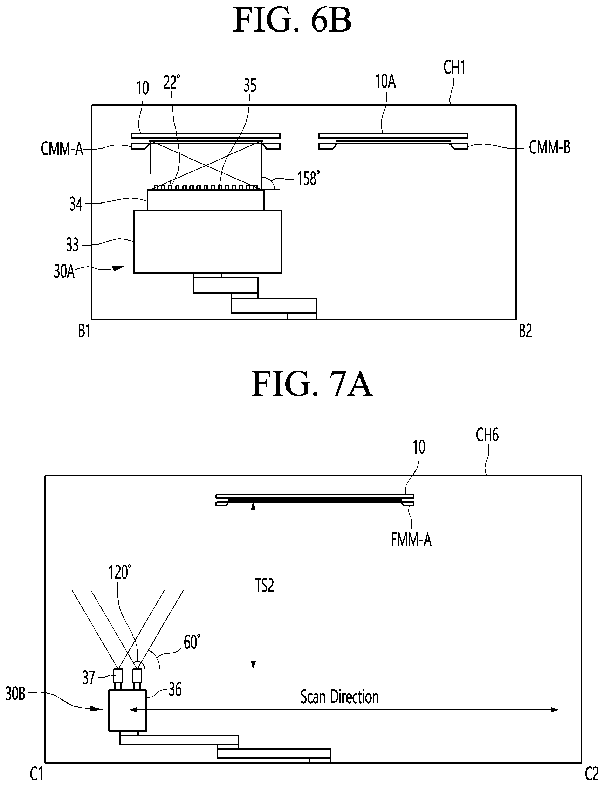

FIG. 6A is a cross-sectional view taken along line A1-A2 in the first deposition equipment of FIG. 5. FIG. 6B is a cross-sectional view taken along line B1-B2 in the first deposition equipment of FIG.

As shown in FIGS. 6A and 6B, the first deposition equipment CH1 may comprise an evaporation source device 30A. The evaporation source device 30A may be positioned at the lower side of the chamber. The evaporation source device 30A may comprise a body 33, a plurality of linear sources 34, etc. on the body 33. The body 33 may be movable in the X-axis, the Y-axis, and/or the Z-axis. The plurality of linear sources 34 may each have a rectangular hexahedron shape elongated in a direction orthogonal to the scan direction. The scan direction may be a transport direction of the body 33, for example, a direction away from the first transport module TM1. Although the drawing illustrates three linear sources 34 disposed along the scan direction, more linear sources may be provided.

A plurality of nozzles 35 may be installed on an upper side of each of the plurality of linear sources 34 along an orthogonal direction. The deposition material can be sprayed through the plurality of nozzles 35.

The first deposition equipment CH1 can sequentially or simultaneously deposit different substrates 10 using two CMMs CMM-A and CMM-B.

Meanwhile, for excellent film quality of the deposition material deposited on the substrate 10, excellent homogeneity and uniformity are required. Homogeneity refers to film quality performance of the deposition material deposited along the scan direction with respect to the substrate 10, and uniformity refers to film quality performance of the deposition material deposited along the orthogonal direction with respect to the substrate 10.

The target-source distance TS1 in the linear source 34 can be small. For example, the target-source distance TS1 in the linear source 34 can be 500 mm. Under these conditions, as shown in Table 1, the range of the deposition angle of the linear source 34 in the scan direction to improve the homogeneity can be 60° to 120° (FIG. 6A), and the range of the deposition angle of the linear source 34 in the orthogonal direction to improve the uniformity can be 22° to 158° (FIG. 6B). That is, even if the range of the deposition angle of the linear source 34 in the scan direction is 60° to 120° under the condition that the target-source distance TS1 in the linear source 34 is small, the homogeneity of the deposition material deposited on the substrate 10 can be very excellent.

In contrast, under the condition that the target-source distance TS1 in the linear source 34 is small, the range of the deposition angle of the linear source 34 in the orthogonal direction is such that when the deposition angle of the deposition material discharged from the nozzle 35 positioned at the leftmost is 22°, as shown in FIG. 6B, the deposition material can also be deposited on the rightmost end region of the substrate 10. When the deposition angle of the deposition material discharged from the nozzle 35 positioned at the rightmost is 158°, the deposition material can also be deposited on the leftmost end region of the substrate 10. Therefore, when the range of the deposition angle of the linear source 34 in the orthogonal direction is 22° to 158°, the uniformity of the deposition material deposited on the substrate 10 in the orthogonal direction can be improved.

As described above, an evaporation source device having the same structure as the evaporation source device 30A equipped in the first deposition equipment CH1 can be equipped in the seventh deposition equipment CH7 and the eighth deposition equipment CH8. That is, the first deposition equipment CH1, the seventh deposition equipment CH7, and the eighth deposition equipment CH8 may comprise a body 33, a plurality of linear sources 34, etc. on the body 33. At this time, the target-source distance TS1 of the evaporation source devices respectively provided in the first deposition equipment CH1, the seventh deposition equipment CH7, and the eighth deposition equipment CH8 may be the same, but is not limited thereto.

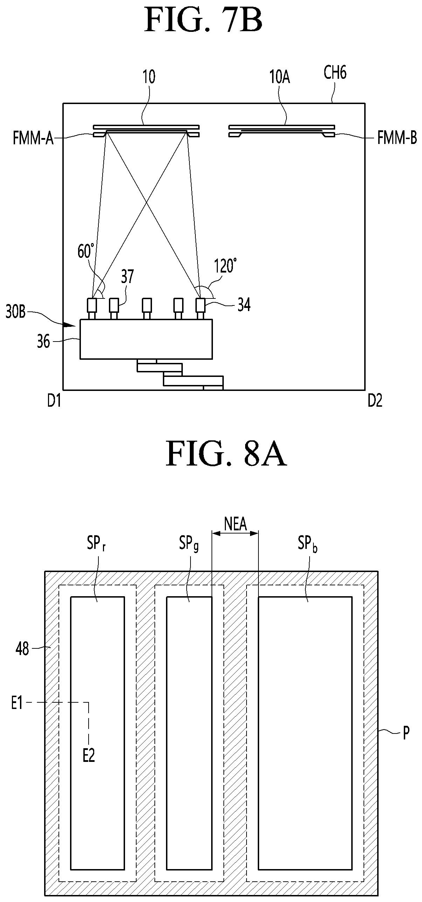

FIG. 7A is a cross-sectional view taken along the line C1-C2 in the sixth deposition equipment of FIG. 5. FIG. 7B is a cross-sectional view taken along the line D1-D2 in the sixth deposition equipment of FIG. 5.

As shown in Figs. 7A and 7B, the sixth deposition equipment CH6 may comprise an evaporation source device 30B. The evaporation source device 30B may be positioned at the lower side of the chamber. The evaporation source device 30B may comprise a body 36, a plurality of point sources 37, etc. on the body 36. The body 36 may be movable in the X-axis, Y-axis, and/or Z-axis. A nozzle may be installed on the upper side of each of the plurality of point sources 37. One nozzle is installed per point source 37, but more nozzles may be installed. The deposition material may be sprayed through the nozzle. The drawing shows two point sources 37 disposed along the scan direction and five point sources 37 disposed along the orthogonal direction, but more point sources may be provided.

The sixth deposition equipment CH6 may sequentially or simultaneously deposit different substrates 10 using two FMMs FMM-A and FMM-B.

In an embodiment, the target-source distance TS2 at the point source 37 may be large. For example, the target-source distance TS2 at the point source 37 may be at least four times or more the target-source distance TS1 at the linear source (34 of FIG. 6A). That is, the point source 37 can be positioned at least four times or more farther from the substrate 10 than the linear source 34. For example, the target-source distance TS2 at the point source 37 can be 2,500 mm.

Under these conditions, as shown in Table 1, the range of the deposition angle of the point source 37 in the scan direction can be 60° to 120° to improve the homogeneity (FIG. 7A), and the range of the deposition angle of the point source 37 in the orthogonal direction can be 60° to 120° to improve the uniformity (FIG. 7B). That is, the range of the deposition angle of the point source 37 in the scan direction and the range of the deposition angle of the point source 37 in the orthogonal direction orthogonal to the scan direction can be the same.

As in FIGS. 7A and 7B, even if the range of the deposition angle of the point source 37 in the scan direction and the range of the deposition angle of the point source 37 in the orthogonal direction orthogonal to the scan direction are the same, the homogeneity of the deposition material deposited on the substrate 10 along the scan direction can be very excellent, and the uniformity of the deposition material deposited on the substrate 10 along the orthogonal direction can be excellent. Since the target-source distance TS2 at the point source 37 is large, even if the range of the deposition angle of the point source 37 in the orthogonal direction is 60° to 120°, which is greater than the range of the deposition angle of the linear source 34, the uniformity of the deposition material deposited on the substrate 10 along the orthogonal direction can be further improved.

[Table 2]

| | | First deposition equipment CH1 (FIG. 6A and FIG. 6B) | Sixth deposition equipment CH6 (FIG. 7A and FIG. 7B) |
|---|---|---|---|
| | Type of source | Linear source 34 | Point source 37 |
| | Target-source distance | 500mm | 2,500m |
| Range of deposition angle | Scan direction | 60° ~ 120° | 60° ~ 120° |
| | Orthogonal direction | 22° ~ 158° | 60° ~ 120° |
| Stroke of evaporation source device | | ~3,400mm | ~5,900mm |

In Table 2, the range of deposition angle in the scan direction and/or the range of deposition angle in the orthogonal direction may vary as the target-source distance TS1 and TS2 are changed, but are not limited thereto. In the sixth deposition equipment CH6 using FMMs FMM-A and FMM-B, the heat influence by the point source 37 can be reduced, two kinds of deposition materials, such as host and dopant, can be deposited with excellent homogeneity, and the shadow influence can be reduced compared to the first deposition equipment CH1 using CMMs CMM-A and CMM-B. To this end, as shown in Table 2, the target-source distance TS2 at the point source 37 in the sixth deposition equipment CH6 can be at least four times or more greater than the target-source distance TS1 at the linear source 34 in the first deposition equipment CH1, and the range of the deposition angle in the scan direction and the range of the deposition angle in the orthogonal direction can be 60° to 120°, respectively. On the other hand, if the target-source distance TS2 increases, the utilization efficiency of the organic material may decrease and a limitation in the deposition angle adjustment may occur. In order to solve this problem, a point source 37 may be included in the evaporation source device 30B that discharges the organic deposition material. For example, in the sixth deposition equipment CH6, the nozzle of the point source 37 may be designed to satisfy a deposition angle range of 60° to 120° at all angles comprising the scan direction and the orthogonal direction. In addition, the target-source distance TS2 of the point source 37 may be designed to be at least 2,500 mm or more to satisfy a deposition angle range of 60° to 120° at all angles. Through deposition by the point source 37 designed in this way, the utilization efficiency of the organic material may be improved and the limitation of the deposition angle adjustment may be removed.

In Table 2, the stroke of the evaporation source device may be the reciprocating movement distance of the evaporation source devices 30A and 30B, and as shown in FIG. 5, in the deposition system 100 according to the first embodiment, that is, the cluster-type deposition system, the evaporation source devices 30A and 30B of each deposition equipment CH1 to CH8 can perform a reciprocating scan for the substrate 10 in order to deposit on a large-area substrate 10. The stroke may mean the movement distance that the evaporation source devices 30A and 30B reciprocally scan for the substrate 10. As illustrated in Table 2, the evaporation source device 30A of the first deposition equipment CH 1 may have a stroke of up to 3,400 mm, and the evaporation source device 30B of the sixth deposition equipment CH6 may have a stroke of up to 5,900 mm. Although not shown, in the inline-type deposition system, the substrate 10 can perform a reciprocating scan for the evaporation source devices 30A and 30B of each deposition equipment CH1 to CH8 for deposition onto a large-area substrate 10.

As described above, an evaporation source device having the same structure as the evaporation source device 30B equipped in the sixth deposition equipment CH6 can be equipped in the second deposition equipment CH2 and the fifth deposition equipment CH5. That is, the second deposition equipment CH2 to the sixth deposition equipment CH6 can comprise a body 36, a plurality of point sources 37 on the body 36, etc. At this time, the target-source distance TS2 of the evaporation source devices 30B equipped in each of the second deposition equipment CH2 to the sixth deposition equipment CH6 can be the same, but is not limited thereto.

Meanwhile, the evaporation source devices 30A and 30B of each of the first deposition equipment CH1 to the eighth deposition equipment CH8 can be moved in the X-axis, Y-axis, and/or Z-axis. Therefore, the range of the target-source distance TS2 or the deposition angle in each direction orthogonal to the scan direction can be changed at any time to secure optimal homogeneity and uniformity.

[Deposition equipment and deposition system using a protrusion part on a substrate]

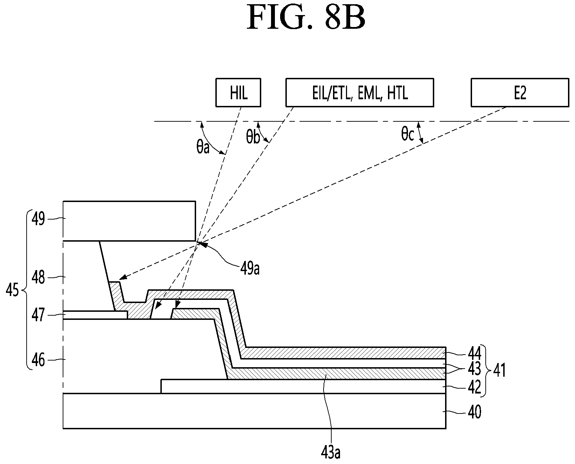

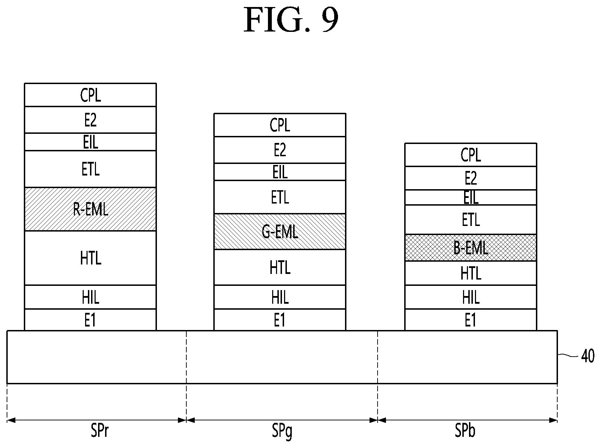

FIG. 8A is a plan view illustrating a red subpixel, a green subpixel, and a blue subpixel constituting one pixel on a substrate having a protrusion part according to an embodiment. FIG. 8B is a cross-sectional view taken along the line E1-E2 in the pixel of FIG. 8A. FIG. 9 illustrates a red organic light-emitting element, a green organic light-emitting element, and a blue organic light-emitting element deposited on the substrate of FIG. 8B.

As shown in FIGS. 8A and 8B, one pixel P may comprise a red subpixel SPr, a green subpixel SPg, and a blue subpixel SPb. Although three subpixels SPr, SPg, and SPb are illustrated in the drawings, more subpixels may be included in one pixel P.

A red organic light-emitting element 41 may be disposed in the red subpixel SPr, a green organic light-emitting element may be disposed in the green subpixel SPg, and a blue organic light-emitting element may be disposed in the blue subpixel SPb. An organic light-emitting display device capable of displaying an image may be implemented by configuring the red organic light-emitting element 41, the green organic light-emitting element, and the blue organic light-emitting element.

As shown in FIG. 8B, the red organic light-emitting element 41 may comprise an anode electrode 42, a red organic emitting layer 43 comprising a hole injection layer 43a, and a cathode electrode 44. Although not shown, each of the green organic light-emitting element and the blue organic light-emitting element may have different materials of the organic emitting layer, and the other layers may have the same structure as the corresponding layers of the red organic light-emitting element 41.

A protrusion part 45 may be positioned between a red subpixel SPr, a green subpixel SPg, and a blue subpixel SPb. The protrusion part 45 may be positioned on a bank 46. The bank 46 and the protrusion part 45 may be positioned on a non-emissive portion NEA.

Since the protrusion part 45 acts as a mask for depositing the corresponding organic light-emitting element on each subpixel SPr, SPg, and SPb, a separate mask such as an FMM may be not required, and an emission region having a larger area may be secured compared to deposition using an FMM, so that a long lifespan can be implemented.

The protrusion part 45 may comprise a first layer 47, a second layer 48, and a third layer 49. For example, the first layer 47 and the second layer 48 may be metal layers, and the third layer 49 may be an insulating layer, but are not limited thereto.

The side portion of the first layer 47 may extend from the side portion of the second layer 48 in the direction of the adjacent subpixel SPr. The first layer 47 may be omitted. The side portion of the third layer 49 may extend from the side portion of the second layer 48 in the direction of the adjacent subpixel SPr. Accordingly, an undercut structure may be formed by the extended side portion of the third layer 49 and the side portion of each of the first layer 47 and the second layer 48. An edge 49a may be provided at a lower end of the extended side portion of the third layer 49. A deposition angle (or a range of deposition angle) of a deposition material deposited on the bank 46 or within the undercut structure may be limited or determined by the edge 49a. In particular, the deposition angle (or a range of deposition angle) of the deposition material may be changed by adjusting the target-source distance of each of the evaporation source devices 210 to 270 together with the edge 49a.

As shown in FIG. 8B, various deposition materials can be deposited on the bank 46 or within the undercut structure at different deposition angles by controlling the target-source distance between the edge 49a and each evaporation source device 210 to 270.

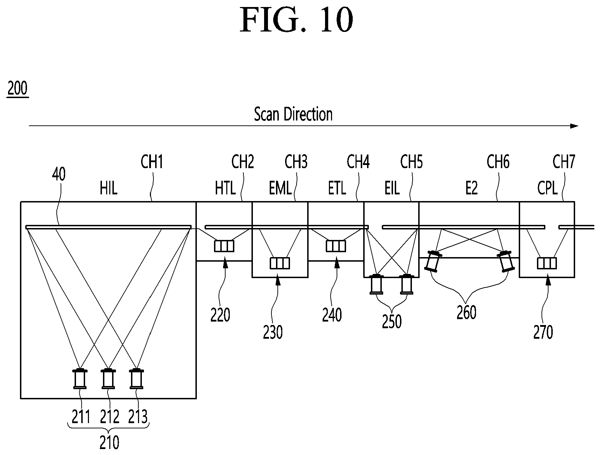

For example, the hole injection layer 43a can be deposited on the bank 46 at a first deposition angle $\theta a$ through the target-source distance of the first evaporation source device (210 of FIG. 10) and the edge 49a.

For example, the hole transport layer, the red organic emitting layer, the electron transport layer, and the electron injection layer can be deposited on the bank 46 at the same deposition angle, i.e., the second deposition angle $\theta b$. The second deposition angle $\theta b$ can be smaller than the first deposition angle $\theta a$. For this purpose, since the edge 49a is provided at a fixed position, the target-source distance of each of the second evaporation source device (220 of FIG. 10) to the fifth evaporation source device 250 may be smaller than the target-source distance of the first evaporation source device 210. The target-source distance of each of the second evaporation source device 220 to the fifth evaporation source device 250 may be the same, but is not limited thereto.

For example, the cathode electrode 44 may be deposited on the first layer 47 and/or the second layer 48 of the protrusion part 45 at a third deposition angle $\theta c$ through the target-source distance of the sixth evaporation source device 260 and the edge 49a. The third deposition angle $\theta c$ may be smaller than the second deposition angle $\theta b$. For this purpose, since the edge 49a is provided at a fixed position, the target-source distance of the sixth evaporation source device 260 may be smaller than the target-source distance of each of the second evaporation source devices 220 to the fifth evaporation source devices 250.

The first evaporation source devices 210 to the sixth evaporation source devices 260 may be included in the first deposition equipment CH1 to the sixth deposition equipment CH6, respectively.

In summary, the larger the target-source distance, the larger the deposition angle. As the deposition angle increases, the end of the layer formed with the corresponding deposition material may be positioned closer to the side portion of the bank 46.

As shown in FIG. 8B, the organic light-emitting material discharged at the largest first deposition angle $\theta a$ by the first evaporation source device 210 having the largest target-source distance may be deposited closest to the side portion of the bank 46 as the hole injection layer 43a. The hole injection layer 43a should not be electrically connected to the cathode electrode 44 or the first layer 47 and/or the second layer 48 of the protrusion part 45 as a low-resistance organic light-emitting material. Therefore, the low-resistance organic light-emitting material can be deposited closest to the side portion of the bank 46 by being discharged at the largest first deposition angle $\theta a$ by the first evaporation source device 210 having the largest target-to-source distance, and can be physically separated from and electrically disconnected from the cathode electrode 44 or the first layer 47 and/or the second layer 48 of the protrusion part 45.

Then, the organic light-emitting material discharged at the next largest second deposition angle $\theta b$ by each of the second evaporation source devices 220 to 250 having the next largest target-to-source distance can be deposited further away from the side portion of the bank 46 as a hole transport layer, a red organic emitting layer, an electron transport layer ETL, and an electron injection layer. For example, the hole transport layer, the red organic emitting layer R-EML, the electron transport layer ETL, and the electron injection layer can be deposited not only on the upper surface of the hole injection layer 43a but also on the upper surface of the bank 46.

The metal material discharged at the smallest third deposition angle $\theta c$ by the sixth evaporation source device 260 having the smallest target-source distance can be deposited farthest from the side portion of the bank 46 as the cathode electrode 44. That is, the cathode electrode 44 can be deposited not only on the upper surface of the bank 46 but also on the first layer 47 and the second layer 48 of the protrusion part 45.

As shown in FIG. 9, a red organic light-emitting element, a green organic light-emitting element, and a blue organic light-emitting element can be disposed on the substrate. That is, a red organic light-emitting element may be disposed in a red subpixel SPr, a green organic light-emitting element may be disposed in a green subpixel SPg, and a blue organic light-emitting element may be disposed in a blue subpixel SPb.

The red organic light-emitting element, the green organic light-emitting element, and the blue organic light-emitting element may each comprise an anode electrode E1, a hole injection layer HIL, a hole transport layer HTL, organic emitting layers R-EML, G-EML, and B-EML, an electron transport layer ETL, an electron injection layer EIL, a cathode electrode E2, a capping layer CPL, etc. Since the red organic light-emitting element, the green organic light-emitting element, and the blue organic light-emitting element have been described in FIG. 4, a detailed description thereof will be omitted.

FIG. 10 is a cross-sectional view illustrating a deposition system according to a second embodiment.

Referring to FIG. 10, the deposition system 200 according to the second embodiment may be an inline-type deposition system, but is not limited thereto. FIG. 10 may be an inline-type deposition system for depositing a red organic light-emitting element (41 in FIG. 8A, FIG. 8B, and FIG. 9). Although not shown, an inline-type deposition system for depositing the green organic light-emitting element and the blue organic light-emitting element shown in FIG. 9 may also be provided. For example, in the inline-type deposition system shown in FIG. 9, a substrate 40 on which a red organic light-emitting element 41 is deposited may be taken out from the seventh deposition equipment CH7 and transferred to an inline-type deposition system for depositing a green organic light-emitting element. Similarly, a substrate 40 on which a red organic light-emitting element 41 and a green organic light-emitting element are deposited may be taken out from the corresponding inline-type deposition system and transferred to an inline-type deposition system for depositing a blue organic light-emitting element.

The deposition system 200 according to the second embodiment may comprise the first deposition equipment CH1 to the seventh deposition equipment CH7, but is not limited thereto. The first deposition equipment CH1 to the seventh deposition equipment CH7 may be disposed along a line. The loading equipment LL may be connected to the front end of the first deposition equipment CH1, and the unloading equipment may be connected to the rear end of the seventh deposition equipment CH7.

The substrate 40 may sequentially pass through the first deposition equipment CH1 to the seventh deposition equipment CH7, so that a red organic light-emitting element may be deposited on the substrate 40.

The first deposition equipment CH1 may deposit a hole injection layer HIL on the substrate 40, and the second deposition equipment CH2 may deposit a hole transport layer HTL on the hole injection layer HIL.

The third deposition equipment CH3 may deposit a red organic emitting layer R-EML, a green organic emitting layer G-EML, and a blue organic emitting layer B-EML on the corresponding hole transport layer HTL.

The fourth deposition equipment CH4 can deposit the electron transport layer ETL on the corresponding red organic emitting layer R-EML, the green organic emitting layer G-EML, and the blue organic emitting layer B-EML.

The fifth deposition equipment CH5 can deposit the electron injection layer EIL on the electron transport layer ETL, the sixth deposition equipment CH6 can deposit the cathode electrode E2 on the electron injection layer EIL, and the seventh deposition equipment CH7 can deposit the capping layer CPL on the cathode electrode E2.

The first deposition equipment CH1 to the seventh deposition equipment CH7 can comprise the first evaporation source device 210 to the seventh evaporation source device 270, respectively. The first evaporation source device 210 to the seventh evaporation source device 270 can each be positioned at the lower side of the chamber. The substrate 40 can be positioned at the upper side of the chamber. Therefore, the deposition material discharged from each of the first evaporation source devices 210 to the seventh evaporation source devices 270 can be sprayed upward toward the substrate 40.

As shown in FIG. 8B, one ends of the hole injection layer HIL, the hole transport layer HTL, the organic emitting layers R-EML, G-EML, and B-EML, the electron transport layer ETL, the electron injection layer EIL, the cathode electrode E2, and the capping layer CPL may be positioned differently from each other. One ends of the hole transport layer HTL, the organic emitting layers R-EML, G-EML, and B-EML, the electron transport layer ETL, and the electron injection layer EIL may be positioned identically, but are not limited thereto. As described above, one end of the hole injection layer HIL may be positioned at a point furthest from the second layer 48 of the protrusion part 45, and one end of each of the hole transport layer HTL, the organic emitting layers R-EML, G-EML, and B-EML, the electron transport layer ETL, and the electron injection layer EIL may be positioned at the next furthest point from the second layer 48 of the protrusion part 45. One end of the cathode electrode E2 can be positioned on the first layer 47 and the second layer 48 of the protrusion part 45.

In this way, the target-source distance of each of the first evaporation source devices 210 to the seventh evaporation source devices 270 of the first deposition equipment CH1 to the seventh deposition equipment CH7 may be different, so that the one-side ends of the hole injection layer HIL, the hole transport layer HTL, the organic light-emitting layers R-EML, G-EML and B-EML, the electron transport layer ETL, the electron injection layer EIL, the cathode electrode E2 and the capping layer CPL may be positioned differently from each other,

The first evaporation source devices 210 to the seventh evaporation source devices 270 may comprise a point source or a linear source. When the target-source distance is large, the corresponding evaporation source device may comprise a point source, and when the target-source distance is small, the corresponding evaporation source device may comprise a linear source.

The first evaporation source device 210, the fifth evaporation source device 250, and the sixth evaporation source device 260 of the first deposition equipment CH1, the fifth deposition equipment CH5, and the sixth deposition equipment CH6 may comprise a plurality of point sources, respectively. The fifth evaporation source device 250 and the sixth evaporation source device 260 may comprise a plurality of linear sources, respectively. The second evaporation source devices 220 to the fourth evaporation source devices 240 and the seventh evaporation source device 270 of the second deposition equipment CH2 to the fourth deposition equipment CH4 and the seventh deposition equipment CH7 may comprise a plurality of linear sources, respectively.

Although not shown, the point source or the linear source may be attached to a body that can move in the X-axis, the Y-axis, and/or the Z-axis.

The range of deposition angle in each of the first evaporation source device 210 to the seventh evaporation source device 270 in the first deposition equipment CH1 to the seventh deposition equipment CH7 is as shown in Table 3.

[Table 3]

| Deposition equipment | Deposition material | Range of deposition angle |
|---|---|---|
| CH1 | HIL | 60°~ 120° |
| CH2 | HTL | 55° ~ 125° |
| CH3 | B-EML | 55° ~ 125° |
| | G-EML | 55° ~ 125° |
| | R-EML | 55° ~ 125° |
| CH4 | ETL | 55° ~ 125° |
| CH5 | EIL | 55° ~ 125° |
| CH6 | E2 | 20° ~ 160° |
| CH7 | CPL | 55° ~ 125° |

In Table 3, the range of deposition angle may be a range of deposition angle in the scan direction, but is not limited thereto. As shown in Table 3, the hole injection layer HIL can be deposited on the substrate 40 at a deposition angle range of 60° to 120° using the point source 211 to 213 of the first evaporation source device 210 in the first deposition equipment CH1. One end of the hole injection layer HIL can be positioned closest to the side portion of the bank (46 in FIG. 8B). Preferably, the deposition angle range of the point source 211 to 213 can be 70° to 110°. In the second deposition equipment CH2 to the fifth deposition equipment CH5 and in the seventh deposition equipment CH7, the second evaporation source devices 220 to the fifth evaporation source devices 250 and the seventh evaporation source device 270 can deposit a hole transport layer HTL, an organic emitting layer R-EML, G-EML and B-EML, an electron transport layer ETL, an electron injection layer EIL and a capping layer CPL on the substrate 40 at a deposition angle range of 55° to 125° using a linear source or a point source. In the instance, one end of each of the hole transport layer HTL, the organic emitting layers R-EML, G-EML and B-EML, the electron transport layer ETL, the electron injection layer EIL and the capping layer CPL can be positioned farther from a side portion of the bank 46 than one end of the hole injection layer HIL. In other words, one end of each of the hole transport layer HTL, the organic emitting layers R-EML, G-EML, and B-EML, the electron transport layer ETL, the electron injection layer EIL, and the capping layer CPL can be positioned closer to the second layer 48 of the protrusion part 45.

In the sixth deposition equipment CH6, the sixth evaporation source device 260 can deposit the cathode electrode E2 on the substrate 40 at a deposition angle range of 20° to 160° using a point source or a linear source. In the instance, one end of the cathode electrode E2 can be positioned farthest from the side portion of the bank 46. In other words, one end of the cathode electrode E2 can be deposited on the first layer 47 and the second layer 48 of the protrusion part 45.

As shown in FIG. 10, the target-source distance of the point source 211 to 213 of the first evaporation source device 210 may be at least four times or more greater than the target-source distance of the linear source of each of the second evaporation source device 220 to the fourth evaporation source device 240.

As described above, by using the deposition system 200 according to the second embodiment as shown in FIG. 10, mass production can be secured, and the problems of yield and image quality and the problems of material cost and the increased equipment investment cost can be resolved, so that price competitiveness can be secured.

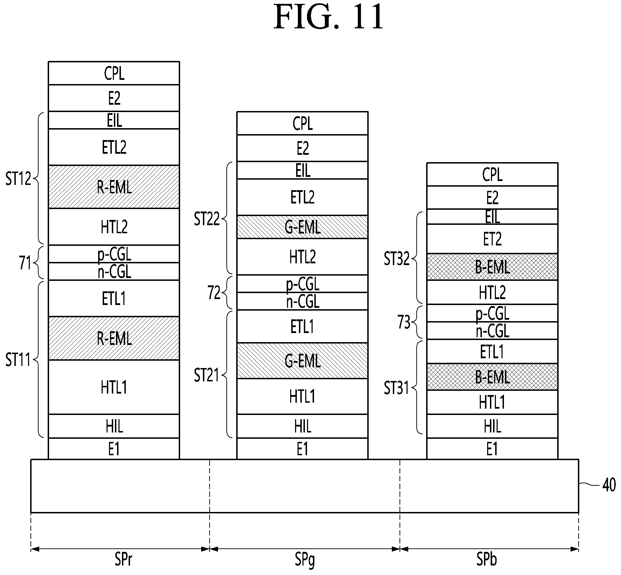

FIG. 11 illustrates a red organic light-emitting element, a green organic light-emitting element, and a blue organic light-emitting element each having a two-stack structure deposited on the substrate of FIG. 8B.

As shown in FIG. 11, a red organic light-emitting element 41, a green organic light-emitting element, and a blue organic light-emitting element, each having a two-stack structure, may be disposed on a substrate 40 having a protrusion part (45 of FIG. 8B).

The red organic light-emitting element 41 may comprise an anode electrode E1, a first organic light-emitting stack ST11 on the anode electrode E1, a charge generation layer 71 on the first organic light-emitting stack ST11, a second organic light-emitting stack ST12 on the charge generation layer 71, a cathode electrode E2 on the second organic light-emitting stack ST12, and a capping layer CPL on the cathode electrode E2.

The green organic light-emitting element may comprise an anode electrode E1, a first organic light-emitting stack ST21 on the anode electrode E1, a charge generation layer 72 on the first organic light-emitting stack ST21, a second organic light-emitting stack ST22 on the charge generation layer 72, a cathode electrode E2 on the second organic light-emitting stack ST22, and a capping layer CPL on the cathode electrode E2.

The blue organic light-emitting element may comprise an anode electrode E1, a first organic light-emitting stack ST31 on the anode electrode E1, a charge generation layer 73 on the first organic light-emitting stack ST31, a second organic light-emitting stack ST32 on the charge generation layer 73, a cathode electrode E2 on the second organic light-emitting stack ST32, and a capping layer CPL on the cathode electrode E2.

The charge generation layer 71 to 73 may comprise an n-type charge generation layer n-CGL and a p-type charge generation layer p-CGL on the n-type charge generation layer n-CGL.

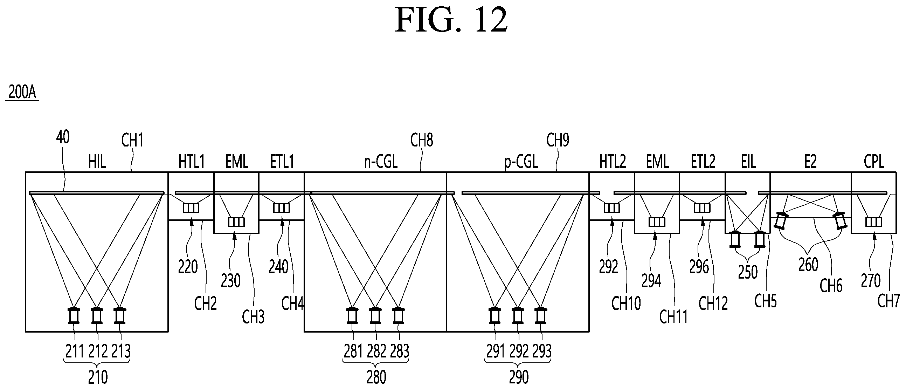

FIG. 12 is a cross-sectional view illustrating a deposition system according to a third embodiment.

Referring to FIG. 12, the deposition system 200A according to the third embodiment may be an inline-type deposition system. The deposition system 200A according to the third embodiment may deposit one of the red organic light-emitting element 41, the green organic light-emitting element, and the blue organic light-emitting element having a two-stack structure shown in FIG. 11.

For convenience of explanation, the deposition system 200A according to the third embodiment may be a deposition system for depositing the red organic light-emitting element 41. In the instance, a deposition system for depositing each of the green organic light-emitting element and the blue organic light-emitting element may be provided separately.

Compared with the deposition system 200 according to the second embodiment, the deposition system 200A according to the third embodiment may further comprise the eighth deposition equipment CH8 to the twelfth deposition equipment CH12.

The first organic light-emitting stack ST11 may be deposited by the second deposition equipment CH2 to the fourth deposition equipment CH4. The charge generation layer 71 may be deposited by the eighth deposition equipment CH8 and the ninth deposition equipment CH9. Specifically, the n-type charge generation layer n-CGL may be deposited by the eighth deposition equipment CH8, and the p-type charge generation layer p-CGL may be deposited by the ninth deposition equipment CH9. The second organic light-emitting stack ST12 may be deposited by the tenth deposition equipment CH10 to the twelfth deposition equipment CH12.

The range of deposition angle in each of the first evaporation source device 210 to the twelfth evaporation source device 296 in the first deposition equipment CH1 to the twelfth deposition equipment CH12 is as shown in Table 4.

[Table 4]

| Deposition equipment | Deposition material | Range of deposition angle |
|---|---|---|
| CH1 | HIL | 60°~ 120° |
| CH2 | HTL1 | 55° ~ 125° |
| CH3 | B-EML | 55° ~ 125° |
| | G-EML | 55° ~ 125° |
| | R-EML | 55° ~ 125° |
| CH4 | ETL1 | 55° ~ 125° |
| CH8 | n-CGL | 60°~ 120° |
| CH9 | p-CGL | 60°~ 120° |
| CH10 | HTL2 | 55° ~ 125° |
| CH11 | B-EML | 55° ~ 125° |
| | G-EML | 55° ~ 125° |
| | R-EML | 55° ~ 125° |
| CH12 | ETL2 | 55° ~ 125° |

(continued)

| Deposition equipment | Deposition material | Range of deposition angle |
|---|---|---|
| CH5 | EIL | 55° ~ 125° |
| CH6 | E2 | 20° ~ 160° |
| CH7 | CPL | 55° ~ 125° |

In Table 4, the first evaporation source device 210, the eighth evaporation source device 280 and the ninth evaporation source device 290 in the first deposition equipment CH1, the eighth deposition equipment CH8 and the ninth deposition equipment CH9 may comprise a plurality of point sources 211 to 213, 281 to 283 and 291 to 293, respectively. The range of the deposition angle in each of the point sources 211 to 213, 281 to 283 and 291 to 293 may preferably be 70° to 110°. As shown in FIG. 8B and FIG. 9, since the charge generation layer 71 is also a low-resistance organic light-emitting material, it must be electrically disconnected from the cathode electrode E2 or the first layer 47 and the second layer 48 of the protrusion part 45. To this end, the seventh evaporation source device 270 and the eighth evaporation source device 280 in the eighth deposition equipment CH8 and the ninth deposition equipment CH9 for depositing the charge generation layer 71 may comprise the point sources 281 to 283 and 291 to 293, respectively. In addition, the target-source distance of each of the point sources 281 to 283 and 291 to 293 may be at least four times or more greater than the target-source distance of the linear source. Here, the linear source may be included in plural in the second evaporation source devices 220 to 240 of the second deposition equipment CH2 to the fourth deposition equipment CH4 respectively and in the tenth evaporation source devices 292 to 296 of the tenth deposition equipment CH10 to the twelfth deposition equipment CH12 respectively.

As described above, as shown in FIG. 12, by using the deposition system 200A according to the third embodiment, mass production can be secured, and the problems of yield and image quality and the problems of material cost and the increased equipment investment cost can be resolved, so that price competitiveness can be secured.

[Deposition equipment and deposition system using a three-dimensional structure on a substrate]

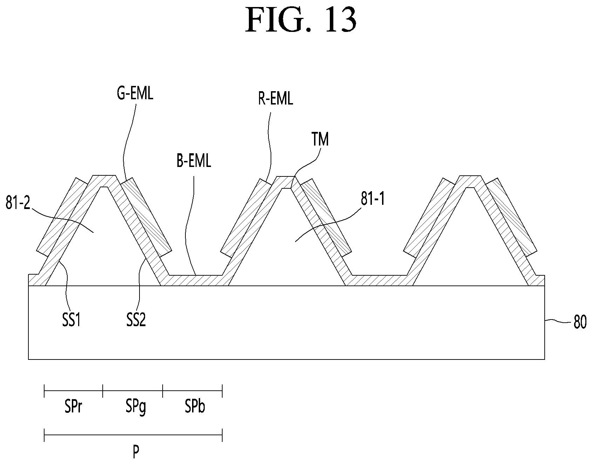

FIG. 13 is a cross-sectional view illustrating a red organic emitting layer, a green organic emitting layer, and a blue organic emitting layer disposed on a substrate having a three-dimensional structure according to an embodiment.

As shown in FIG. 13, a red organic light-emitting element, a green organic light-emitting element, and a blue organic light-emitting element may be disposed on a substrate 80. One pixel P may comprise a red subpixel SPr, a green subpixel SPg, and a blue subpixel SPb. Although three subpixels SPr, SPg, and SPb are illustrated in the drawing, more subpixels may be included in one pixel P. The red organic light-emitting element, the green organic light-emitting element, and the blue organic light-emitting element may comprise a red organic emitting layer R-EML, a green organic emitting layer G-EML, and a blue organic emitting layer B-EML, respectively.

A red organic light-emitting element may be disposed in the red subpixel SPr, a green organic light-emitting element may be disposed in the green subpixel SPg, and a blue organic light-emitting element may be disposed in the blue subpixel SPb. An organic light-emitting display device capable of displaying an image may be implemented through the configuration of the red organic light-emitting element, the green organic light-emitting element, and the blue organic light-emitting element.

Meanwhile, the three-dimensional structures 81-1 and 81-2 may be disposed on the substrate 80. The three-dimensional structures 81-1 and 81-2 may have at least two side surfaces SS1 and SS2. The three-dimensional structures 81-1 and 81-2 may also have a top surface TM, but is not limited thereto.

The three-dimensional structures 81-1 and 81-2 may serve to guide a deposition material to be deposited only on a specific region by using a self-aligned deposition (SAD) method. For example, a red organic emitting layer R-EML may be deposited on the first side surface SS1 of the three-dimensional structures 81-1 and 81-2 by a first organic light-emitting material sprayed in a first diagonal direction toward the substrate 80. For example, a green organic emitting layer G-EML can be deposited on the second side surface SS2 of the three-dimensional structures 81-1 and 81-2 by the second organic light-emitting material sprayed in the second diagonal direction toward the substrate 80. The first side surface SS1 and the second side surface SS2 of the three-dimensional structures 81-1 and 81-2 can have the same inclination angle with respect to the normal direction. The first diagonal direction and the second diagonal direction can be orthogonal to each other.

Meanwhile, the three-dimensional structures 81-1 and 81-2 can act as a mask for self-aligned deposition to allow the organic light-emitting material to be deposited only on a specific side surface of the three-dimensional structures 81-1 and 81-2. Accordingly, since a separate mask such as an FMM is not required, an emission region having a larger area can be secured compared to deposition using an FMM, and a long lifespan can be implemented.

For example, the first organic light-emitting material sprayed in the first diagonal direction may be deposited only on the first side surface SS1 of the first three-dimensional structure 81-1 because it is obstructed by the second three-dimensional structure 81-2. However, the first organic light-emitting material may not be deposited on the second side surface SS2 of the first three-dimensional structure 81-1, the second side surface SS2 of the second three-dimensional structure 81-2, or the gap region between the first three-dimensional structure 81-1 and the second three-dimensional structure 81-2 because it is obstructed by the second three-dimensional structure 81-2. The gap region may be defined on the substrate 80 between the first three-dimensional structure 81-1 and the second three-dimensional structure 81-2.

Similarly, the second organic light-emitting material sprayed in the second diagonal direction may be deposited only on the second side surface SS2 of the second three-dimensional structure 81-2 because it is obstructed by the first three-dimensional structure 81-1. However, the second organic light-emitting material may not be deposited on the first side surface SS1 of the second three-dimensional structure 81-2, the first side surface SS1 of the first three-dimensional structure, or the gap region between the first three-dimensional structure 81-1 and the second three-dimensional structure 81-2 because it is obstructed by the first three-dimensional structure 81-1.

Meanwhile, the third organic light-emitting material sprayed in a direction perpendicular to the substrate 80 may be deposited on the entire area of the substrate 80 without interference by the first three-dimensional structure 81-1 and the second three-dimensional structure 81-2. That is, the third organic light-emitting material may be deposited not only on the gap region on the substrate 80 but also on the first side surface SS1 and the second side surface SS2 of each of the first three-dimensional structure 81-1 and the second three-dimensional structure 81-2. In this way, the third organic light-emitting material may be commonly deposited on each of the subpixels SPr, SPg, and SPb of the substrate 80 as a blue organic emitting layer B-EML. A structure in which the blue organic emitting layer B-EML is commonly deposited in this way is called a blue common structure.

For example, after the first organic light-emitting material is deposited as the blue organic emitting layer B-EML over the entire area of the substrate 80, the second organic light-emitting material may be deposited as the red organic emitting layer R-EML on the first side surface SS1 of the three-dimensional structures 81-1 and 81-2, and the third organic light-emitting material may be deposited as the green organic emitting layer G-EML on the second side surface SS2 of the three-dimensional structures 81-1 and 81-2.

Therefore, as described above, by depositing the red organic emitting layer R-EML, the green organic emitting layer G-EML, and the blue organic emitting layer B-EML on the substrate 80 equipped with the three-dimensional structures 81-1 and 81-2, more pixels P can be included in a small size, so that a high ppi can be implemented and the image quality can be improved.

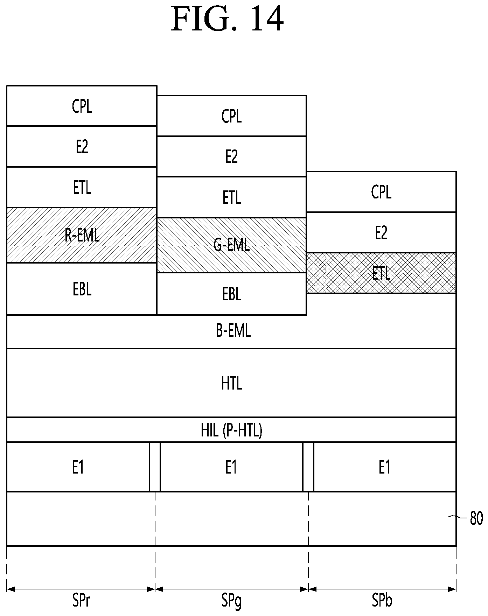

FIG. 14 illustrates a red organic light-emitting element, a green organic light-emitting element, and a blue organic light-emitting element deposited on a substrate having a three-dimensional structure according to an embodiment.

As shown in FIG. 13 and FIG. 14, a red organic light-emitting element, a green organic light-emitting element, and a blue organic light-emitting element may be deposited on a substrate 80.

The red organic light-emitting element, the green organic light-emitting element, and the blue organic light-emitting element may comprise an anode electrode E1, a plurality of organic emitting layers, a cathode electrode E2, and a capping layer CPL. The plurality of organic emitting layers may comprise a hole injection layer HIL, a hole transport layer HTL, an organic emitting layer, an electron transport layer ETL, an electron injection layer, etc. The organic emitting layer may comprise a red organic emitting layer R-EML, a green organic emitting layer G-EML, and a blue organic emitting layer B-EML.

The structure shown in FIG. 14 is known in Korean Publication No. 10-2023-0162567 (published on November 28, 2023), so that a detailed description thereof is omitted.

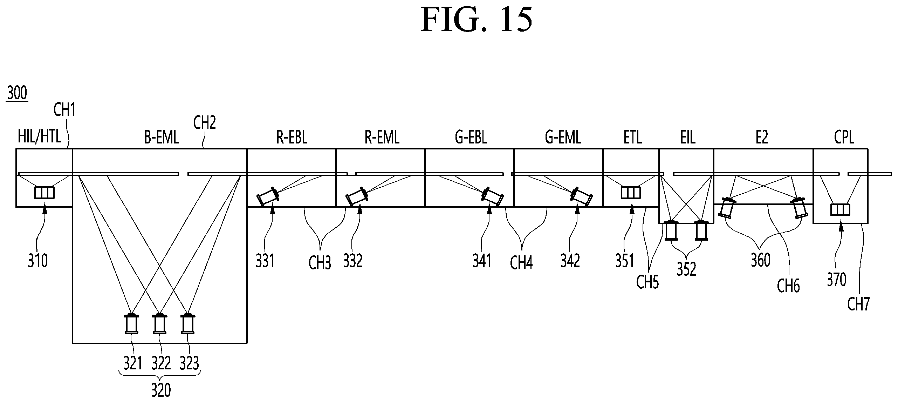

FIG. 15 is a cross-sectional view illustrating a deposition system according to a fourth embodiment.

Referring to FIG. 15, the deposition system 300 according to the fourth embodiment may be an inline-type deposition system. The deposition system 300 according to the fourth embodiment may deposit a red organic light-emitting element, a green organic light-emitting element, and a blue organic light-emitting element on the substrate 80 and the three-dimensional structures 81-1 and 81-2 shown in FIGS. 13 and 14.

The deposition system 300 according to the fourth embodiment may comprise, but is not limited to, the first deposition equipment CH1 to the seventh deposition equipment CH7. The first deposition equipment CH1 to the seventh deposition equipment CH7 may be disposed along a line. A loading equipment LL may be connected to the front end of the first deposition equipment CH1, and an unloading equipment may be connected to the rear end of the seventh deposition equipment CH7.

The first deposition equipment CH1 may deposit a hole injection layer HIL and/or a hole transport layer HTL on the substrate 80, and the second deposition equipment CH2 may deposit a blue organic emitting layer B-EML on the hole transport layer HTL.

The third deposition equipment CH3 may deposit an electron blocking layer R-EBL and a red organic emitting layer R-EML on the blue organic emitting layer B-EML, and the fourth deposition equipment CH4 may deposit an electron blocking layer G-EBL and a green organic emitting layer G-EML on the blue organic emitting layer B-EML. The electron blocking layer R-EBL or the electron blocking layer G-EBL may be omitted.

The fifth deposition equipment CH5 can deposit the electron transport layer ETL and/or the electron injection layer on the blue organic emitting layer B-EML, the red organic emitting layer R-EML, and the green organic emitting layer G-EML. The electron injection layer may be omitted.

The sixth deposition equipment CH6 can deposit the cathode electrode E2 on the electron injection layer, and the seventh deposition equipment CH7 can deposit the capping layer CPL on the cathode electrode E2.

The ranges of the deposition angle in each of the first evaporation source device 310 to the seventh evaporation source device 370 in the first deposition equipment CH1 to the seventh deposition equipment CH7 are as shown in Table 5.

[Table 5]

| Deposition equipment | Deposition material | Range of deposition angle |
| --- | --- | --- |
| CH1 | HIL | 22° ~ 158° |
| | HTL | |
| CH2 | B-EML | 70° ~ 110° |
| CH3 | R-EBL | 20° ~ 30° |
| | R-EML | |
| CH4 | G-EBL | 150° ~ 160° |
| | G-EML | |
| CH5 | ETL | 22° ~ 158° |
| | EIL | |
| CH6 | E2 | 22° ~ 158° |
| CH7 | CPL | 22° ~ 158° |

As shown in FIG. 15, the first deposition equipment CH1 to the seventh deposition equipment CH7 may comprise the first evaporation source device 310 to the seventh evaporation source device 370, respectively. The first deposition equipment CH1 to the seventh deposition equipment CH7 may comprise the first evaporation source device 310 to the seventh evaporation source device 370, respectively. The first evaporation source device 310 to the seventh evaporation source device 370 may be positioned at the lower side of the chamber, respectively. The substrate 80 may be positioned at the upper side of the chamber. Accordingly, the deposition material discharged from each of the first evaporation source device 310 to the seventh evaporation source device 370 may be sprayed upward toward the substrate 80. The second evaporation source device 320 may comprise a plurality of point sources 321 to 323. The third evaporation source device 341, the fourth evaporation source device 342, and the sixth evaporation source device 360 may comprise a plurality of point sources, respectively. The first evaporation source device 310 and the seventh evaporation source device 370 may comprise a plurality of linear sources. The fifth evaporation source device of the fifth deposition equipment CH5 may comprise a fifth-first evaporation source device 351 comprising a plurality of linear sources and a fifth-second evaporation source device 352 comprising a plurality of point sources. An electron transport layer ETL may be deposited on the substrate 80 by the fifth-first evaporation source device 351, and an electron injection layer may be deposited on the electron transport layer ETL by the fifth-second evaporation source device 352.

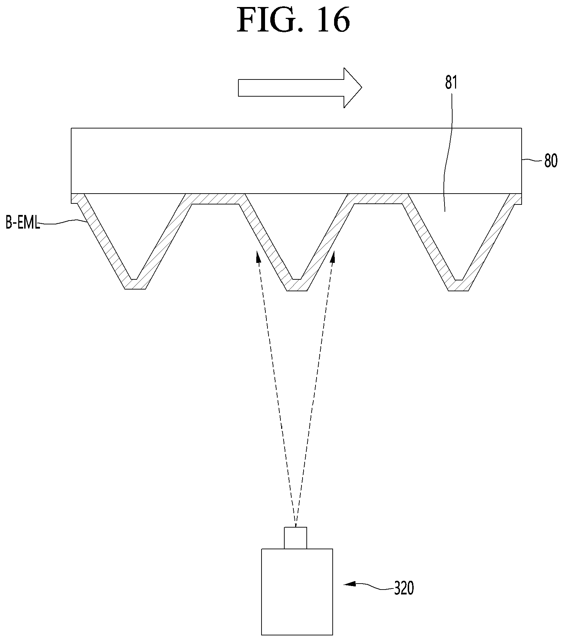

Meanwhile, as shown in FIG. 16, since the deposition material discharged from the second evaporation source device 320, i.e., the blue organic light-emitting material, is sprayed in a vertical direction toward the substrate 80, the second evaporation source device 320 can be spaced far from the substrate 80. To this end, the second evaporation source device 320 can comprise a plurality of point sources. In addition, the target-source distance of the second evaporation source device 320 can be at least four times or more greater than the target-source distance of the seventh evaporation source device 370 comprising a plurality of linear sources. That is, the second evaporation source device 320 can be positioned at a distance from the substrate 80 that is at least four times or more greater than the target-source distance of the seventh evaporation source device 370. In the instance, as shown in Table 5, the range of the deposition angle of the second evaporation source device 320 can be 70° to 110°.

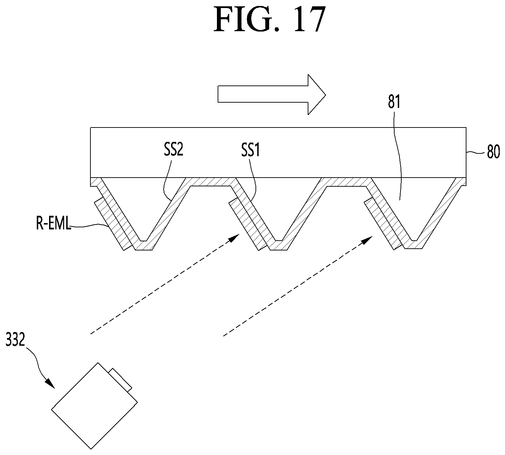

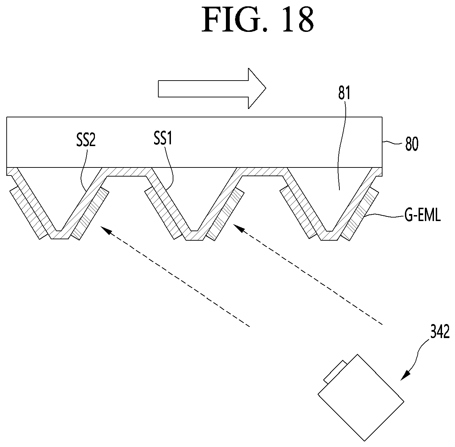

As shown in FIGS. 17 and 18, since the deposition materials discharged from the third evaporation source devices 331 and 332 of the third deposition equipment CH3 and the fourth evaporation source devices 341 and 342 of the fourth deposition equipment CH4, for example, the red organic light-emitting material and the green organic light-emitting material, are sprayed diagonally toward the substrate 80, the third evaporation source devices 331 and 332 and the fourth evaporation source devices 341 and 342 can be positioned in a diagonal direction with respect to the substrate 80. For example, the third evaporation source devices 331 and 332 may be positioned on the left side at the lower side of the chamber in the first diagonal direction with respect to the substrate 80, and the fourth evaporation source devices 341 and 342 may be positioned on the right side at the lower side of the chamber in the second diagonal direction with respect to the substrate 80.

Since the deposition materials discharged from the third evaporation source devices 331 and 332 and the fourth evaporation source devices 341 and 342 must be deposited in a limited manner on the first side surface SS1 and the second side surface SS2 of the three-dimensional structure 81 of the substrate 80, the range of the deposition angle may be very narrow. As shown in Table 5, the range of the deposition angle of the third evaporation source devices 331 and 332 may be 20° to 30°, and the range of the deposition angle of the fourth evaporation source devices 341 and 342 may be 150° to 160°. If the range of the deposition angle is determined based on the horizontal direction or the horizontal line from the right side to the left side, the range of the deposition angle of the third evaporation source devices 331 and 332 may be 150° to 160°, and the range of the deposition angle of the fourth evaporation source devices 341 and 342 may be 20° to 30°.

As described above, as shown in FIG. 15, by using the deposition system 300 according to the fourth embodiment, mass production can be secured, and the problems of yield and image quality and the problems of material cost and the increased equipment investment cost can be resolved, so that price competitiveness can be secured.

[High-angle deposition equipment]

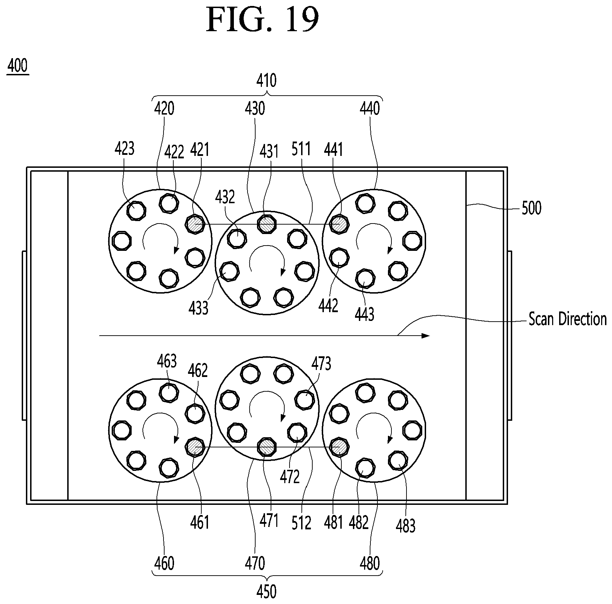

FIG. 19 is a plan view illustrating the deposition equipment according to a first embodiment.

Referring to FIG. 19, the deposition equipment 400 according to the first embodiment may be a high-angle deposition equipment capable of spraying the deposition material in an almost vertical direction. Here, high angle means an angle that allows the deposition material to be sprayed in a range of a deposition angle of at least 60° to 120°.

As described above, among the plurality of deposition equipment of the deposition systems 100, 200, 200A, and 300 according to the first to fourth embodiments, the high angle deposition equipment is as shown in Table 6.

[Table 6]

| | Deposition equipment | Deposition material | Range of deposition angle |
|---|---|---|---|
| First embodiment (FIG. 5) | CH2 내지 CH6 | R-HTL, G-HTL, B-EML, G-EML, R-EML | 60° ~ 120° |
| Second embodiment (FIG. 10) | CH1 | HIL | 60° ~ 120° |
| Third embodiment (FIG. 12) | CH1, CH5, CH6 | HIL, n-CGL, p-CGL | 60° ~ 120° |
| Fourth embodiment (FIG. 15) | CH2 | B-EML | 70° ~ 110° |

As shown in Table 6, in the deposition system according to the first embodiment (100 of FIG. 5), the second evaporation source device to the sixth evaporation source device of the second deposition equipment CH2 to the sixth deposition equipment CH6 may comprise a plurality of point sources, respectively. As shown in FIGS. 2, 3, and 5, by depositing the deposition material on the substrate 10 at a deposition angle ranging from 60° to 120° in the second to sixth evaporation source devices, respectively, an electron transport layer ETL, an electron transport layer ETL, a blue organic light-emitting layer B-EML, a green organic light-emitting layer G-EML, and a red organic light-emitting layer R-EML can be formed. In the deposition system according to the second embodiment (200 of FIG. 10), the first evaporation source device 210 of the first deposition equipment CH1 can comprise a plurality of point sources. As shown in FIGS. 8A, 8B, 9, and 10, by depositing the deposition material on the substrate 40 at a deposition angle ranging from 60° to 120° in the first evaporation source device 210, a hole injection layer HIL can be formed. In the deposition system according to the third embodiment (200A of FIG. 12), the first evaporation source device 210, the fifth evaporation source device 250, and the sixth evaporation source device 260 of the first deposition equipment CH1, the fifth deposition equipment CH5, and the sixth deposition equipment CH6 may comprise a plurality of point sources, respectively. As shown in FIGS. 8A, 8B, 11, and 12, by depositing the deposition material on the substrate 40 at a deposition angle range of 60° to 120° in the first evaporation source device 210, the fifth evaporation source device 250 and the sixth evaporation source device 260, respectively, a hole injection layer HIL, an n-type charge generation layer n-CGL and a p-type charge generation layer p-CGL can be formed.

In the deposition system according to the fourth embodiment (300 of FIG. 15), the second evaporation source device 320 of the second deposition equipment CH2 may comprise a plurality of point sources. As shown in FIGS. 13 to 15, by depositing the deposition material on the substrate 80 at a deposition angle range of 70° to 110° in the second evaporation source device 320, a blue organic light-emitting layer B-EML can be formed.

Meanwhile, as shown in FIG. 19, the deposition equipment 400 according to the first embodiment can comprise two evaporation source devices 410 and 450. That is, the first evaporation source device 410 and the second evaporation source device 450 can be positioned spaced apart from each other. For example, with respect to a virtual line defined along a scan direction, the first evaporation source device 410 can be positioned above the virtual line, and the second evaporation source device 450 can be positioned below the virtual line. In the instance, the first evaporation source device 410 may spray the deposition material onto the lower surface of one side of the substrate 500, and the second evaporation source device 450 may spray the deposition material onto the lower surface of the other side of the substrate 500.

The first evaporation source device 410 may comprise the first-first evaporation source device 420, the first-second evaporation source device 430, and the first-third evaporation source device 440. For example, the first-first evaporation source device 420, the first-second evaporation source device 430, and the first-third evaporation source device 440 may be installed adjacent to each other along the scan direction. Although three evaporation source devices 420 to 440 are illustrated in the drawing, more evaporation source devices may be provided.

The first-second evaporation source device 430 may comprise a dopant material as a deposition material, and the first-first evaporation source device 420 and the first-third evaporation source device 440 may each comprise a host material as a deposition material.

The evaporation source device 420 may comprise a plurality of first-first point sources 421 to 423 disposed in a circular shape along a circumference of its upper side, the first-second evaporation source device 430 may comprise a plurality of first-second point sources 431 to 433 disposed in a circular shape along a circumference of its upper side, and the first-third evaporation source device 440 may comprise a plurality of first-third point sources 441 to 443 disposed in a circular shape along a circumference of its upper side. The drawing shows seven point sources 421 to 423, seven point sources 431 to 433, and seven point sources 441 to 443, but more point sources may be provided.

The first-first point sources 421 to 423, the first-second point sources 431 to 433 and 1-3 and the first-third point sources 441 to 443 can be inserted into the body, respectively. The first-first point sources 421 to 423, the first-second point sources 431 to 433 and 1-3 and the first-third point sources 441 to 443 can be detached from the body, respectively. A point source whose deposition material has been exhausted can be rotated by a certain angle and replaced with a new point source.

Among the plurality of first-first point sources 421 to 423, one 421 may be currently being used in the evaporation process, another 422 may be preliminarily heated for use in the next evaporation process, and the others 423 may be in standby.

Among the plurality of first-second point sources 431 to 433, one 421 may be currently being used in the evaporation process, another 422 may be being preliminarily heated for use in the next evaporation process, and the others 423 may be on standby.

Among the plurality of first-third point sources 441 to 443, one 441 may be currently being used in the evaporation process, another 442 may be being preliminarily heated for use in the next evaporation process, and the others 443 may be in standby.

In the instance, one 421 among the plurality of first-first point sources 421 to 423, one 431 among the plurality of first-second point sources 431 to 433, and one 441 among the plurality of first-third point sources 441 to 443 may be positioned on a straight line 511 and may be used in the current evaporation process. Here, the direction of the straight line 511 may be the same as the scan direction. Accordingly, by depositing the host material discharged from the first-first evaporation source device 420, the dopant material discharged from the first-second evaporation source device 430, and the host material discharged from the first-third evaporation source device 440 in that order on the substrate 500 along the scan direction, the homogeneity of the deposition film deposited on the substrate 500 can be improved.

When the deposition material of one 421 among the plurality of first-first point sources 421 to 423, one 431 among the plurality of first-second point sources 431 to 433, or one 441 among the plurality of first-third point sources 441 to 443 positioned on a straight line 511 is exhausted, the first-first evaporation source device 420, the first-second evaporation source device 430, and/or the first-third evaporation source device 440 may be rotated so that another 422 among the plurality of first-first point sources 421 to 423, another 432 among the plurality of first-second point sources 431 to 433, and/or another 442 among the plurality of first-third point sources 441 to 443 can be positioned on the straight line 511 and can be used in the evaporation process. At this time, the rotation may be clockwise, but is not limited thereto.

The evaporation source device 450 may comprise a second-first evaporation source device 460, a second-second evaporation source device 470, and a second-third evaporation source device 480. For example, the second-first evaporation source device 460, the second-second evaporation source device 470, and the second-third evaporation source device 480 may be installed adjacent to each other along the scan direction. Although three point sources 460 to 480 are illustrated in the drawing, more point sources may be provided.

The second-second evaporation source device 470 may comprise a dopant material as a deposition material, and the second-first evaporation source device 460 and the second-third evaporation source device 480 may each comprise a host material as a deposition material.

The evaporation source device 460 may comprise a plurality of second-first point sources 461 to 463 disposed in a circular shape along a circumference of its upper side, the second-second evaporation source device 470 may comprise a plurality of second-second point sources 471 to 473 disposed in a circular shape along a circumference of its upper side, and the second-third evaporation source device 480 may comprise a plurality of second-third point sources 481 to 483 disposed in a circular shape along a circumference of its upper side. Although the drawing illustrates seven second-first point sources 461 to 463, seven second-second point sources 471 to 473, and seven second-third point sources 481 to 483, more point sources may be provided.

The second-first point sources 461 to 463, the second-second point sources 471 to 473, and the second-third point sources 481 to 483 can be inserted into the body, respectively. The second-first point sources 461 to 463, the second-second point sources 471 to 473, and the second-third point sources 481 to 483 can be detached from the body, respectively. A point source whose deposition material has been exhausted can be rotated by a certain angle and replaced with a new point source.

Among the plurality of second-first point sources 461 to 463, one 461 is currently being used in the evaporation process, another 462 is being preliminarily heated for use in the next evaporation process, and the others 463 can be in standby.

Among the plurality of second-second point sources 471 to 473, one 471 may be currently being used in the evaporation process, another 472 may be preliminarily heated for use in the next evaporation process, and the others 473 may be in standby.

Among the plurality of second-third point sources 481 to 483, one 481 may be currently being used in the evaporation process, another 482 may be preliminarily heated for use in the next evaporation process, and the others 483 may be in standby. In the instance, one 461 among the plurality of second-first point sources 461 to 463, one 471 among the plurality of second-second point sources 471 to 473, and one 481 among the plurality of second-third point sources 481 to 483 may be positioned on a straight line 512. Here, the direction of the straight line 512 may be the same as the scan direction. Accordingly, by depositing the host material discharged from the second-first evaporation source device 460, the dopant material discharged from the second-second evaporation source device 470, and the host material discharged from the second-third evaporation source device 480 in that order on the substrate 500 along the scan direction, the homogeneity of the deposition film deposited on the substrate 500 can be improved.

When the deposition material of one 461 among the plurality of second-first point sources 461 to 463, one 471 among the plurality of second-second point sources 471 to 473, or one 481 among the plurality of second-third point sources 481 to 483 positioned on a straight line 512 is exhausted, the second-first point source, the second-second evaporation source device 470, and/or the second-third evaporation source device 480 may be rotated so that another 462 among the plurality of second-first point sources 461 to 463, another 472 among the plurality of second-second point sources 471 to 473, and/or another 482 among the plurality of second-third point sources 481 to 483 may be positioned on the straight line 512. At this time, the rotation may be clockwise, but is not limited thereto.

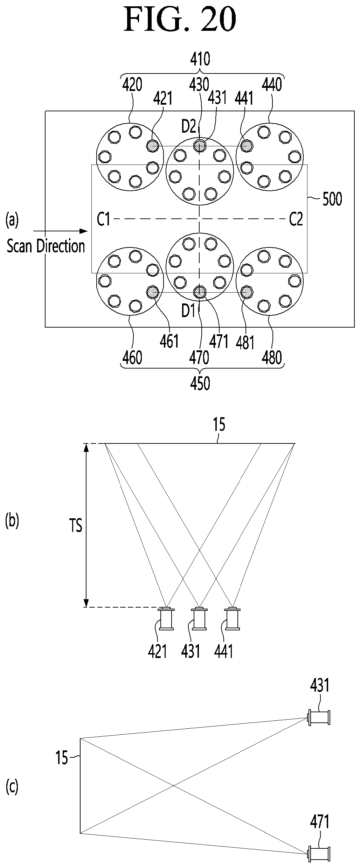

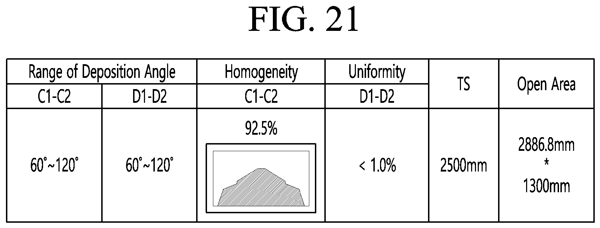

FIG. 20A is a plan view illustrating a deposition equipment according to a first embodiment. FIG. 20B illustrates a view along the C1-C2 line in the deposition equipment according to the first embodiment. FIG. 20C illustrates a view along the D1-D2 line in the deposition equipment according to the first embodiment. FIG. 21 is a table illustrating deposition characteristics in the deposition equipment according to a first embodiment.

As shown in FIGS. 20A, 20B, and 20C, the deposition equipment according to the first embodiment may be equipped with a first evaporation source device 410 and a second evaporation source device 450, each comprising a plurality of point source 420 to 440 and 460 to 480 having a cylindrical structure.

As shown in FIG. 20A, FIG. 20B, FIG. 20C and FIG. 21, the target-source distance TS of the point source 420 to 440 and 460 to 480 may be at least four times or more greater than the target-source distance TS of the linear source. For example, the target-source distance TS of the point source 420 to 440 and 460 to 480 may be 2,500 mm. Here, the point sources may be the first-first evaporation source device 420, the first-second evaporation source device 430, the first-third evaporation source device 440, the second-first evaporation source device 460, the second-second evaporation source device 470 and/or the second-third evaporation source device 480 in FIG. 20A. In the instance, the range of the deposition angle in each of the point source 420 to 440 and 460 to 480 in the scan direction may be 60° to 120°, and the range of the deposition angle in each of the point sources 420 to 440 and 460 to 480 in the orthogonal direction orthogonal to the scan direction may be 60° to 120°. The homogeneity of the film deposited on the substrate 500 can be very excellent at 92.5%, and the uniformity can be also very excellent at less than 1%.

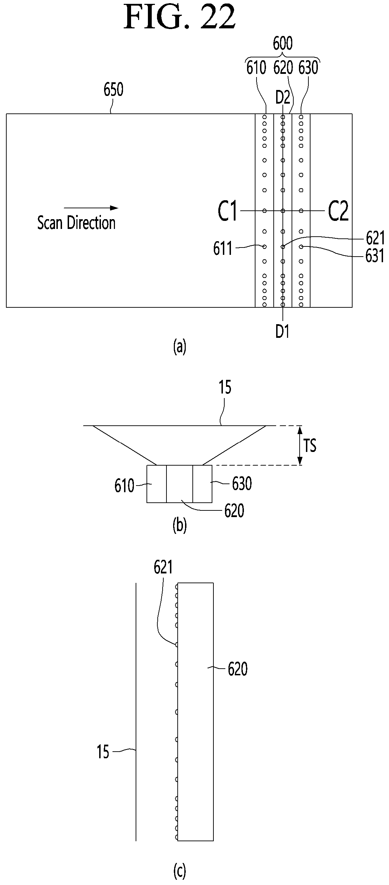

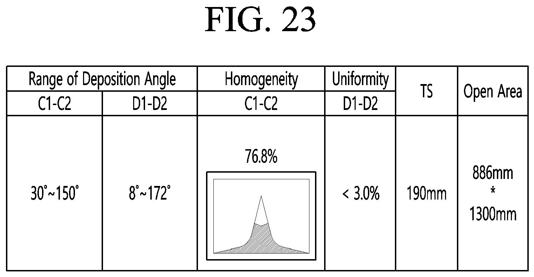

FIG. 22A is a plan view illustrating a deposition equipment according to a second embodiment. FIG. 22B illustrates a view along the C1-C2 line in the deposition equipment according to the second embodiment. FIG. 22C illustrates a view along the D1-D2 line in the deposition equipment according to the second embodiment. FIG. 23 is a table illustrating deposition characteristics in the deposition equipment according to the second embodiment.

As shown in FIG. 22A, FIG. 22B and FIG. 22C, the deposition equipment according to the second embodiment may comprise an evaporation source device 600 comprising a plurality of linear sources 610 to 630. The plurality of linear sources 610 to 630 may comprise a plurality of nozzles 611 to 613 provided on their upper sides, respectively.

The deposition equipment according to the embodiment may be applied to the first deposition equipment CH1, the fifth deposition equipment CH5 and the seventh deposition equipment CH7 in the deposition system (300 of FIG. 15) according to the fourth embodiment. The first evaporation source device 310 of the first deposition equipment CH1, the fifth-first evaporation source device 351 of the fifth deposition equipment CH5 and the seventh evaporation source device 370 of the seventh deposition equipment CH7 may comprise a plurality of linear sources. For example, the plurality of linear sources may be installed along the scan direction. In the instance, the plurality of linear sources may each have a rectangular hexahedron structure elongated along the orthogonal direction of the scan direction.

As shown in FIGS. 22A, 22B, 22C, and 23, the target-source TS of the linear source may be 190 mm. Here, the linear source may comprise at least one or more of the plurality of linear sources 610 to 630 in FIG. 22A. In the instance, the range of the deposition angle in each of the linear sources 610 to 630 in the scan direction may be 30° to 150°, and the range of the deposition angle in each of the linear sources 610 to 630 in the orthogonal direction of the scan direction may be 8° to 172°. The homogeneity of the film deposited on the substrate 650 may be 76.8%, and the uniformity may be less than 3%.

The deposition equipment according to the embodiment can be useful for depositing a common layer that has good material utilization efficiency and does not affect homogeneity by not applying mixed materials (host and dopant). The common layer can be a layer that is simultaneously formed in common over the entire area of the substrate, that is, over the red subpixel SPr, the green subpixel SPg, and the blue subpixel SPb.

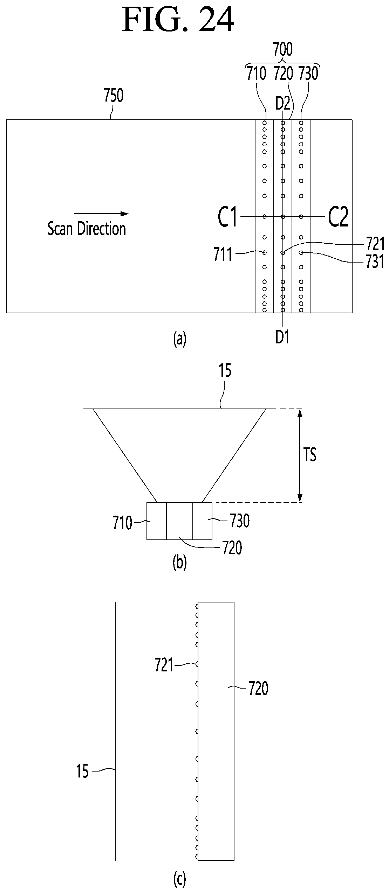

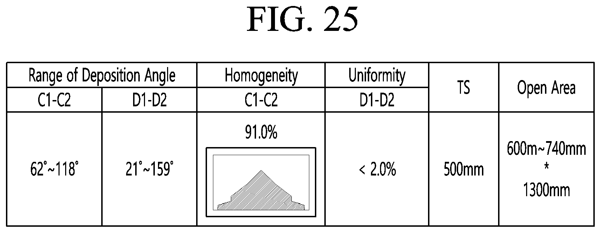

FIG. 24A is a plan view illustrating a deposition equipment according to a third embodiment. FIG. 24B illustrates a view along the C1-C2 line in the deposition equipment according to the third embodiment. FIG. 24C illustrates a view along the D1-D2 line in the deposition equipment according to the third embodiment. FIG. 25 is a table illustrating deposition characteristics in the deposition equipment according to the third embodiment.

As shown in FIGS. 24A, 24B, and 24C, the deposition equipment according to the third embodiment may comprise an evaporation source device 700 comprising a plurality of linear sources 710 to 730. For example, the plurality of linear sources 710 to 730 may be installed along the scan direction. In the instance, the plurality of linear sources 710 to 730 may each have a rectangular hexahedron structure elongated along a direction orthogonal to the scan direction. The plurality of linear sources 710 to 730 may each comprise a plurality of nozzles 711 to 713 provided on the upper side thereof.

As shown in FIGS. 24A, 24B, 24C, and 25, the target-source TS of each of the linear sources 710 to 730 may be 500 mm, which may be greater than the target-source TS of each of the linear sources 610 to 630 shown in FIG. 22. In the instance, the range of the deposition angle of the linear sources 710 to 730 in the scan direction may be 62° to 118°, and the range of the deposition angle of the linear sources 710 to 730 in the direction orthogonal to the scan direction may be 21° to 159°. The homogeneity of the film deposited on the substrate 750 can be very excellent at 91.0%, and the uniformity can be excellent at less than 2%.

The deposition equipment according to the embodiment can be useful for depositing a common layer or an organic emitting layer that affects homogeneity by applying a mixed material (host and dopant). Preferably, the deposition equipment according to the third embodiment has relatively little heat transfer, so that it can be usefully applied to deposition equipment (CH2 to CH6 of FIG. 5) using FMM.

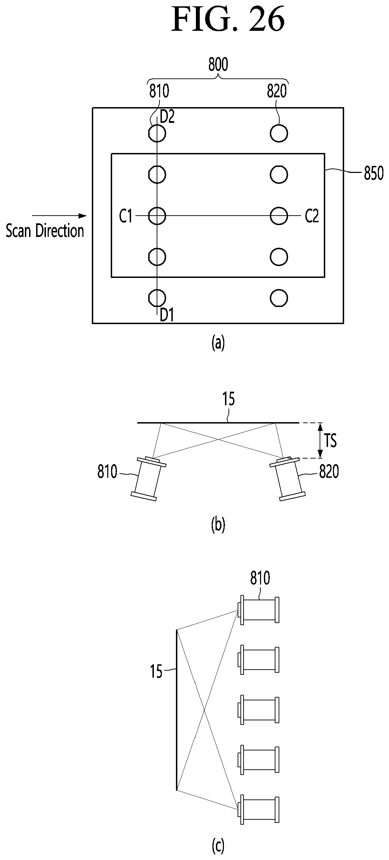

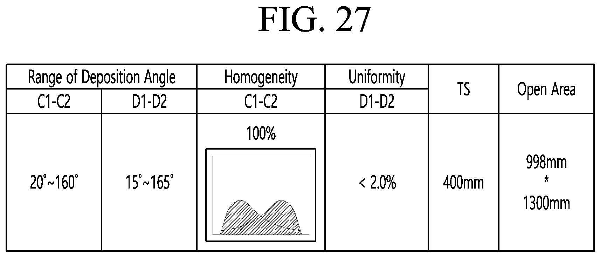

FIG. 26A is a plan view illustrating a deposition equipment according to a fourth embodiment. FIG. 26B illustrates a view along the C1-C2 line in the deposition equipment according to the fourth embodiment. FIG. 26C illustrates a view along the D1-D2 line in the deposition equipment according to the fourth embodiment. FIG. 27 is a table showing deposition characteristics in the deposition equipment according to the fourth embodiment.

As shown in FIG. 26A, FIG. 26B and FIG. 26C, the deposition equipment according to the fourth embodiment may comprise an evaporation source device 800 comprising two point source columns 810 and 820, each having a cylindrical structure. The two point source columns 810 and 820 may each comprise a plurality of point sources.

The first point source column 810 may be arranged along an orthogonal direction, and the second point source column 820 may be arranged along an orthogonal direction spaced apart from the first point source column 810.

The first point source column 810 may be installed adjacent to a start point in a scan direction, and the second point source column may be installed adjacent to an end point in the scan direction. The plurality of point sources included in the first point source column 810 may be installed to be inclined in a first diagonal direction with respect to the substrate 850. A plurality of point sources included in the second point source column 820 may be installed to be inclined in a second diagonal direction with respect to the substrate 850. The first diagonal direction and the second diagonal direction may be orthogonal to each other.

The deposition equipment according to the fourth embodiment having the above-described structure may be applied to the sixth deposition equipment CH6 of the deposition system (200 of FIG. 10) according to the second embodiment, the sixth deposition equipment CH6 of the deposition system (200A of FIG. 12) according to the third embodiment, and the sixth deposition equipment CH6 of the deposition system (300 of FIG. 15) according to the fourth embodiment.

As shown in FIGS. 26A, 26B, 26C, and 27, the target-source TS of the point source may be 400 mm. The point source may comprise at least one or more of the plurality of point sources in FIG. 26A. In the instance, the range of the deposition angle of the point source in the scan direction can be 20° to 160°, and the range of the deposition angle of the point source in the orthogonal direction orthogonal to the scan direction can be 15° to 165°. The homogeneity of the film deposited on the substrate 850 is perfect at 100%, and the uniformity can be excellent at less than 2%.

The deposition equipment according to the embodiment can be applied to a deposition equipment that reduces the target-source distance TS of the point source to satisfy the product by reducing the deposition angle, thereby reducing the heat transfer relatively.

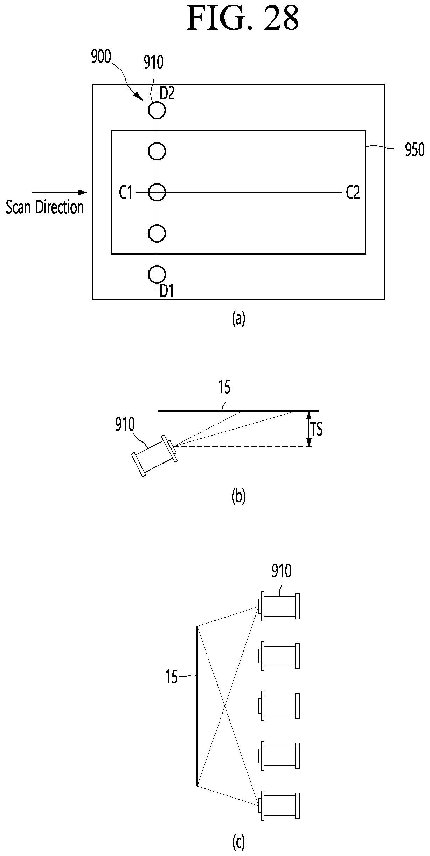

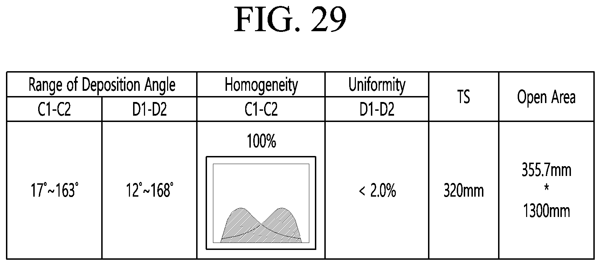

FIG. 28A is a plan view illustrating the deposition equipment according to a fifth embodiment. FIG. 28B illustrates a view along the C1-C2 line in the deposition equipment according to the fifth embodiment. FIG. 28C illustrates a view along the D1-D2 line in the deposition equipment according to the fifth embodiment. FIG. 29 is a table showing the deposition characteristics in the deposition equipment according to the fifth embodiment.

As shown in FIG. 28A, FIG. 28B, and FIG. 28C, the deposition equipment according to the fifth embodiment may be applied to a deposition equipment for depositing a deposition material using a self-aligned deposition method on a substrate 80 equipped with a three-dimensional structure (81-1 and 81-2 of FIG. 13). For example, the deposition equipment according to the fifth embodiment may be applied to the third deposition equipment CH3 and the fourth deposition equipment CH4 of the deposition system (300 of FIG. 15) according to the fourth embodiment.

The evaporation source device 900 of the deposition equipment according to the embodiment may comprise a plurality of point sources 910. The plurality of point sources 910 may be installed in a row along an orthogonal direction. The plurality of point sources 910 may be installed in a diagonal direction with respect to the substrate.

As shown in FIG. 28A, FIG. 28B, FIG. 28C and FIG. 29, the target-source TS of the point source 910 can be 320 mm. In the instance, the range of the deposition angle of the point source 910 in the scan direction can be 17° to 163°, and the range of the deposition angle of the point source 910 in the orthogonal direction orthogonal to the scan direction can be 12° to 168°. The homogeneity of the film deposited on the substrate is perfect at 100%, and the uniformity can be excellent at less than 2%.

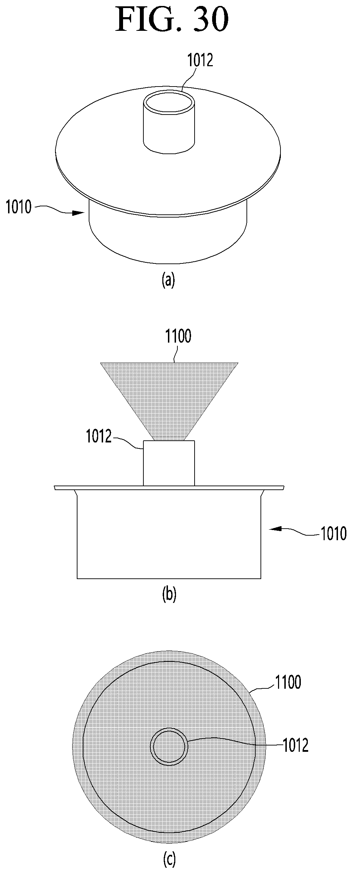

The nozzle provided on the upper side of the point source can have various shapes. The nozzle provided on the upper side of the point source can adjust the deposition angle (or the range of the deposition angle) and/or the discharge direction of the deposition material according to the change in the shape of the discharge port. The nozzle will be described with reference to FIGS. 30A to 32C.

FIG. 30A, FIG. 30B, and FIG. 30C illustrate a nozzle provided on the upper side of a point source according to the first embodiment.

As shown in FIG. 30A, FIG. 30B, and FIG. 30C, a nozzle 1010 provided on the upper side of a point source according to the first embodiment may comprise a discharge port 1012 that can adjust a deposition angle (or a range of deposition angle) and/or a discharge direction of a deposition material 1100.

The discharge port 1012 has a circular shape, and its end may be positioned at a horizontal plane. Accordingly, the deposition material 1100 may be discharged vertically with respect to the ground from the discharge port 1012.

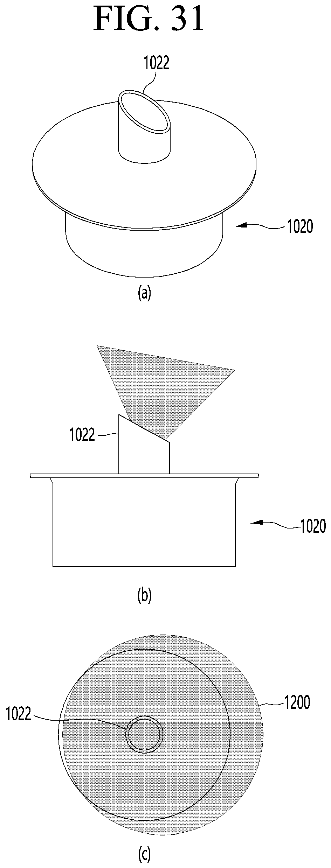

FIG. 31A, FIG. 31B, and FIG. 31C illustrate a nozzle provided on the upper side of a point source according to the second embodiment.

As shown in FIGS. 31A, 31B, and 31C, the nozzle 1020 provided on the upper side of the point source according to the second embodiment may comprise a discharge port 1022 that can adjust the deposition angle (or the range of the deposition angle) and/or the discharge direction of the deposition material 1200.

The discharge port 1022 may have a circular shape, and its end may be positioned at a sloped surface. Accordingly, the deposition material 1200 may be discharged in a diagonal direction with respect to the ground from the discharge port 1022.

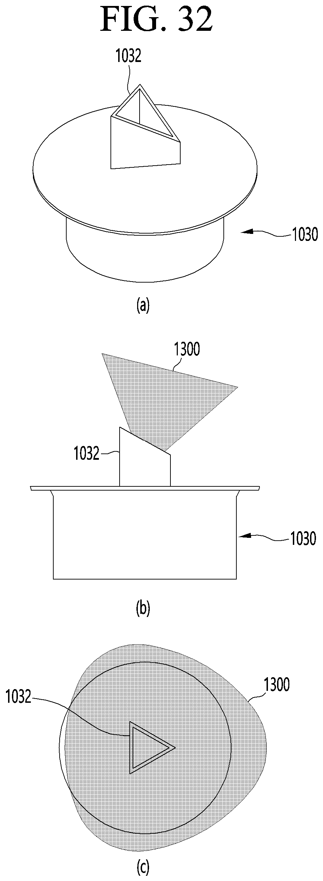

FIGS. 32A, 32B, and 32C illustrate a nozzle provided on the upper side of the point source according to the third embodiment.

As shown in FIG. 32A, FIG. 32B and FIG. 32C, the nozzle 1030 provided on the upper side of the point source according to the third embodiment may comprise a discharge port 1032 that can adjust the deposition angle (or the range of the deposition angle) and/or the discharge direction of the deposition material 1300.

The discharge port 1032 may have a triangle shape, and its end may be positioned at a sloped surface. Accordingly, the deposition material 1300 may be discharged in a diagonal direction with respect to the ground from the discharge port 1032.

As shown in FIG. 31B and FIG. 32B, even if the ends of the discharge ports 1022 and 1032 are positioned at the same sloped surface, the discharge shapes of the deposition materials 1200 and 1300 discharged from the circular discharge port 1022 and the triangular discharge port 1032, respectively, may be different.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

**Claims**

1. A deposition equipment for manufacturing each of a plurality of subpixels having a side-by-side structure on a substrate, comprising:

   an evaporation source device positioned below the substrate to discharge a deposition material toward the substrate,
   wherein the evaporation source device comprises a point source or a linear source, and
   wherein the point source is positioned at a distance from the substrate at least four times or more greater than the linear source.

2. The deposition equipment of claim 1, wherein a range of a deposition angle of the point source in a scan direction and a range of a deposition angle of the point source in a direction orthogonal to the scan direction are the same.

3. The deposition equipment of claim 1, wherein the plurality of subpixels comprises a blue subpixel, a green subpixel, and a red subpixel, and
   wherein the blue subpixel, the green subpixel, and the red subpixel comprise a plurality of organic emitting layers, respectively.

4. The deposition equipment of claim 3, wherein when at least one or more organic emitting layer among the plurality of organic emitting layers is formed on the substrate using a mask positioned between the substrate and the point source, a range of a deposition angle of the point source is 60° to 120°, and
   wherein the at least one or more organic emitting layer is individually formed on the blue subpixel, the green subpixel, and the red subpixel through the mask.

5. The deposition equipment of claim 1, wherein the plurality of subpixels comprises a blue subpixel, a green subpixel, and a red subpixel,

   wherein each of the blue subpixel, the green subpixel, and the red subpixel comprises a hole injection layer on an anode electrode and at least one or more stack structure on the hole injection layer, and
   wherein when the hole injection layer is formed on the substrate using a protrusion part between the plurality of subpixels as a mask, a range of a deposition angle of the point source is 60° to 120°.

6. The deposition equipment of claim 5, wherein the at least or more one stack structure comprises a first stack structure and a second stack structure,

   wherein each of the blue subpixel, the green subpixel, and the red subpixel further comprises a charge generation layer between the first stack structure and the second stack structure, and
   wherein when the charge generation layer is formed on the substrate using a protrusion part as a mask, a range of a deposition angle of the point source is 60° to 120°.

7. The deposition equipment of claim 1, wherein the plurality of subpixels comprises a blue subpixel, a green subpixel, and a red subpixel,

   wherein the blue subpixel, the green subpixel, and the red subpixel commonly comprise a blue organic emitting layer, and
   wherein when a plurality of three-dimensional structures on the substrate are used as masks to form the blue organic emitting layer on the substrate, a range of a deposition angle of the point source is 70° to 110°.

8. The deposition equipment of claim 1, wherein the evaporation source device comprises:

   a first evaporation source device comprising a first-first evaporation source device, a first-second evaporation source device, and a first-third evaporation source device disposed in a row along a scan direction; and
   a second evaporation source device comprising a second-first evaporation source device, a second-second evaporation source device, and a second-third evaporation source device disposed in a row along the scan direction and spaced apart from the first evaporation source device along a direction orthogonal to the scan direction.

9. The deposition equipment of claim 8, wherein each of the first-second evaporation source device and the second-second evaporation source device comprises a dopant material as the deposition material, and

wherein each of the first-first evaporation source device, the first-third evaporation source device, the second-first evaporation source device, and the second-third evaporation source device comprises a host material as the deposition material.

10. The deposition equipment of claim 8, wherein the first-first evaporation source device comprises a plurality of first-first point sources disposed in a circular shape along a circumference of its upper side,

wherein the first-second evaporation source device comprises a plurality of first-second point sources disposed in a circular shape along a circumference of its upper side,
wherein the first-third evaporation source device comprises a plurality of first-third point sources disposed in a circular shape along a circumference of its upper side, and
wherein one of the plurality of first-first point sources, one of the plurality of first-second point sources, and one of the plurality of first-third point sources are positioned on a straight line.

11. The deposition equipment of claim 8, wherein the second-first evaporation source device comprises a plurality of second-first point sources disposed in a circular shape along a circumference of its upper side,

wherein the second-second evaporation source device comprises a plurality of second-second point sources disposed in a circular shape along a circumference of its upper side,
wherein the second-third evaporation source device comprises a plurality of second-third point sources disposed in a circular shape along a circumference of its upper side, and
wherein one of the plurality of second-first point sources, one of the plurality of second-second point sources, and one of the plurality of second-third point sources are positioned on a straight line.

12. The deposition equipment of claim 1, wherein the evaporation source device comprising the point source has a cylindrical structure, and

wherein the evaporation source device comprising the linear source has a rectangular hexahedron structure elongated in a direction orthogonal to a scan direction.

13. A deposition system, comprising:

a plurality of deposition equipment configured in a circular type or an inline type, and
one of the plurality of deposition equipment is a deposition equipment according to one of claims 1-9.

# FIG. 1

P

SP_r      SP_g      SP_b

10

# FIG. 2

SP_b     SP_g     SP_r     SP_b

12-1    12-2    10

11

A

20    20a

TS1

Mg

θ1

31

TS2

θ2

31

# FIG. 3

# FIG. 4

| | | |
|---|---|---|
| CPL | | |
| E2 | CPL | |
| ETL | E2 | CPL |
| R-EML | ETL | E2 |
| | G-EML | ETL |
| R-HTL | G-HTL | B-EML |
| HTL | | |
| HIL | | |
| E1 | E1 | E1 |

— 10

|← SPr →|← SPg →|← SPb →|

# FIG. 5

# FIG. 6A

# FIG. 6B

# FIG. 7A

# FIG. 7B

# FIG. 8A

# FIG. 8B

# FIG. 9

# FIG. 10

# FIG. 11

EP 4 756 070 A1

## FIG. 12

200A

# FIG. 13

G-EML

R-EML

B-EML

TM

81-2

81-1

SS1  SS2

80

SPr  SPg  SPb

P

# FIG. 14

| CPL | | |
|-----|-----|-----|
| E2 | CPL | |
| ETL | E2 | CPL |
| R-EML | ETL | E2 |
| EBL | G-EML | ETL |
| | EBL | |

| B-EML |
|-------|

| HTL |
|-----|

| HIL (P-HTL) |
|-------------|

| E1 | E1 | E1 |
|-----|-----|-----|

~ 80

| SPr | SPg | SPb |

# FIG. 15

EP 4 756 070 A1

# FIG. 16

B-EML

81

80

320

# FIG. 17

# FIG. 18

# FIG. 19

EP 4 756 070 A1

# FIG. 20

45

# FIG. 21

| Range of Deposition Angle | | Homogeneity | Uniformity | TS | Open Area |
|---|---|---|---|---|---|
| C1-C2 | D1-D2 | C1-C2 | D1-D2 | | |
| 60°~120° | 60°~120° | 92.5%<br> | < 1.0% | 2500mm | 2886.8mm<br>*<br>1300mm |

# FIG. 22

(a)

(b)

(c)

# FIG. 23

| Range of Deposition Angle | | Homogeneity | Uniformity | TS | Open Area |
|---|---|---|---|---|---|
| C1-C2 | D1-D2 | C1-C2 | D1-D2 | | |
| 30°~150° | 8°~172° | 76.8% | < 3.0% | 190mm | 886mm * 1300mm |

# FIG. 24

700

710 720 730

750

D2

C1 ——— C2

Scan Direction

711

721
731

(a)

D1

15

TS

710 — 730

720

(b)

721

720

15

(c)

# FIG. 25

| Range of Deposition Angle | | Homogeneity | Uniformity | TS | Open Area |
|---|---|---|---|---|---|
| C1-C2 | D1-D2 | C1-C2 | D1-D2 | | |
| 62°~118° | 21°~159° | 91.0% | < 2.0% | 500mm | 600m~740mm * 1300mm |

# FIG. 26

(a)

(b)

(c)

# FIG. 27

| Range of Deposition Angle | | Homogeneity | Uniformity | TS | Open Area |
|---|---|---|---|---|---|
| C1-C2 | D1-D2 | C1-C2 | D1-D2 | | |
| 20°~160° | 15°~165° | 100%<br> | < 2.0% | 400mm | 998mm<br>*<br>1300mm |

# FIG. 28

(a)

(b)

(c)

# FIG. 29

| Range of Deposition Angle | | Homogeneity | Uniformity | TS | Open Area |
|---|---|---|---|---|---|
| C1-C2 | D1-D2 | C1-C2 | D1-D2 | | |
| 17°~163° | 12°~168° | 100% | < 2.0% | 320mm | 355.7mm * 1300mm |

# FIG. 30

(a)

(b)

(c)

# FIG. 31

1022

1020

(a)

1022

1020

(b)

1022

1200

(c)

# FIG. 32

(a)

(b)

(c)

## INTERNATIONAL SEARCH REPORT

| International application No. |
| --- |
| **PCT/KR2024/095947** |

| | | |
| --- | --- | --- |
| **A.** | **CLASSIFICATION OF SUBJECT MATTER** | |
| | **C23C 14/22**(2006.01)i; **H10K 71/16**(2023.01)i; **H10K 50/15**(2023.01)i; **H10K 50/16**(2023.01)i; **H10K 50/11**(2023.01)i; **H10K 59/80**(2023.01)i; **C23C 14/04**(2006.01)i; **C23C 14/34**(2006.01)i; **C23C 14/24**(2006.01)i | |

According to International Patent Classification (IPC) or to both national classification and IPC

| | |
| --- | --- |
| **B.** | **FIELDS SEARCHED** |

Minimum documentation searched (classification system followed by classification symbols)

C23C 14/22(2006.01); C23C 14/24(2006.01); C23C 14/54(2006.01); C23C 14/56(2006.01); H01L 51/00(2006.01); H01L 51/56(2006.01); H05B 33/10(2006.01); H10K 71/16(2023.01); H10K 71/60(2023.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 증착(deposition), 유기 발광 소자(organic light emitting diode), 증발원(evaporation source), 포인트 소스(point source), 리니어 소스(linear source), 증착각(deposition angle), 마스크(mask)

| | |
| --- | --- |
| **C.** | **DOCUMENTS CONSIDERED TO BE RELEVANT** |

| Category* | Citation of document, with indication, where appropriate, of the relevant passages | Relevant to claim No. |
| --- | --- | --- |
| Y | KR 10-2011-0136950 A (LEE, Young Gu et al.) 22 December 2011 (2011-12-22) See paragraphs [0027] and [0032]-[0033] and figures 3-4a. | 1-13 |
| Y | KR 10-2023-0109109 A (JAPAN DISPLAY INC.) 19 July 2023 (2023-07-19) See paragraphs [0085] and [0089] and figures 7 and 9. | 1-13 |
| Y | JP 5064810 B2 (CANON KABUSHIKI KAISHA) 31 October 2012 (2012-10-31) See paragraph [0021] and figure 2. | 2 |
| Y | KR 10-2019-0126493 A (YAS CO., LTD.) 12 November 2019 (2019-11-12) See paragraph [0040] and figure 8. | 3-7 |
| A | US 2018-0287064 A1 (TIANMA JAPAN, LTD.) 04 October 2018 (2018-10-04) See paragraphs [0091]-[0105], claim 1, and figures 5-8. | 1-13 |

☐ Further documents are listed in the continuation of Box C.     ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **29 October 2024** | **29 October 2024** |

| Name and mailing address of the ISA/KR | Authorized officer |
| --- | --- |
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/095947**

| Patent document cited in search report | | | Publication date (day/month/year) | Patent family member(s) | | | Publication date (day/month/year) |
|---|---|---|---|---|---|---|---|
| KR | 10-2011-0136950 | A | 22 December 2011 | KR | 10-1197403 | B1 | 05 November 2012 |
| KR | 10-2023-0109109 | A | 19 July 2023 | CN | 116426882 | A | 14 July 2023 |
| | | | | JP | 2023-102549 | A | 25 July 2023 |
| | | | | US | 2023-0220548 | A1 | 13 July 2023 |
| JP | 5064810 | B2 | 31 October 2012 | CN | 101024875 | A | 29 August 2007 |
| | | | | JP | 2007-227359 | A | 06 September 2007 |
| | | | | KR | 10-0837475 | B1 | 12 June 2008 |
| | | | | KR | 10-2007-0078713 | A | 01 August 2007 |
| | | | | US | 2007-0178708 | A1 | 02 August 2007 |
| KR | 10-2019-0126493 | A | 12 November 2019 | KR | 10-2019-0126493 | A | 12 November 2019 |
| | | | | KR | 10-2197096 | B1 | 30 December 2020 |
| US | 2018-0287064 | A1 | 04 October 2018 | CN | 108695361 | A | 23 October 2018 |
| | | | | CN | 108695361 | B | 20 June 2023 |
| | | | | JP | 2018-170152 | A | 01 November 2018 |
| | | | | US | 10263185 | B2 | 16 April 2019 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230162567